# EUROPÄISCHE PATENTANMELDUNG

(11) **EP 3 836 399 A1**
(43) Veröffentlichungstag der Anmeldung: **16.06.2021**
(21) Anmeldenummer: 19216085.1
(22) Anmeldetag: 13.12.2019
(51) Int. Cl.: H03K 17/94, G09F 19/18

(54) **SYSTEM ZUR BEREICHSÜBERWACHUNG**

(71) Anmelder: Ammann, Fritz, 8500 Frauenfeld (CH)
(72) Erfinder: Ammann, Fritz, 8500 Frauenfeld (CH)
(74) Vertreter: Herrmann, Johanna

(57) **Zusammenfassung**

Ein System zur Bereichsüberwachung umfasst ein berührungsloses Bedienungselement (0), umfassend mindestens einen berührungslosen Erkennungssensor (4) oder eine entsprechende Schnittstelle. Der berührungslose Erkennungssensor (4) oder die Schnittstelle ist zur Erkennung des Benutzungsobjekts (5) ausgebildet, wenn sich das Benutzungsobjekt (5) in einem Erkennungsbereich (3) befindet, der durch mindestens eine Erkennungsbereichskennzeichnung (6, 7) gekennzeichnet ist.

## Beschreibung

### Hintergrund

Ein System zur Bereichsüberwachung umfasst ein berührungsloses Bedienungselement, welches mindestens einen berührungslosen, fokussierten Erkennungssensor oder eine entsprechende Schnittstelle umfasst. Der Erkennungssensor ist zur Erkennung eines Benutzungsobjekts ausgebildet, wenn es sich in einem Erkennungsbereich befindet, der durch mindestens eine Erkennungsbereichskennzeichnung gekennzeichnet wird.

### Stand der Technik

Vorbekannte sensorausgelöste, berührungslose Näherungsschalter haben üblicherweise einen grossen Erkennungsbereich von üblicherweise 110°. Das Ziel des grossen Erkennungsbereichs ist, dass das Funktionsobjekt vom Benutzungsobjekt in möglichst vielen Positionen ausgelöst werden kann. Der vorbekannte Näherungsschalter benötigt dementsprechend auch keine feste Erkennungsbereichskennzeichnung und auch keine Erkennungsbereichskennzeichnung durch ein Erkennungsbereichskennzeichnungsgerät.

Allerdings kann das dazugehörige Funktionsobjekt nicht selektiv ausgelöst werden, denn die Auslösung erfolgt immer, das heisst zwangsläufig. Zudem ist der Erkennungsbereich nicht genau markiert. Somit werden mit vorbekannten Näherungsschaltern die Funktionsobjekte teilweise auch dann angesteuert, wenn dies gar nicht gewünscht war. Deswegen können Näherungsschalter wegen des grossen Erkennungsbereichs auch nicht für alle Funktionsobjekte beispielsweise bei Licht, Fenstern, Türen, Tore, Jalousien, Marquisen, Stören, Aufzüge, Anlagen oder Flüssigkeitsansteuerungen, elektronische Geräte, Maschinen, Geräte, Fortbewegungsmittel, Fahrzeuge, Flugzeuge und Wasserfahrzeuge, Automaten, Ampeln oder Automaten verwendet werden, speziell wenn die unbeabsichtigte Veränderung beim Funktionsobjekt störend ist.

Aufgrund seines Aufbaus kann das berührungslose Bedienungselement vom Benutzungsobjekt bewusst und selektiv und/oder auf seiner kontinuierlichen, ununterbrochenen Bewegung zum Funktionsobjekt ausgelöst respektive nicht ausgelöst werden. Eine allfällige Erkennung im Erkennungsbereich erfolgt durch Präsenz und damit beispielsweise auch in Bewegung und/oder ohne einen speziellen Ablauf und/oder ohne eine spezielle Handlung und/oder ohne eine spezielle Geste oder Deutung und/oder ohne ein spezielles Körperteil des Benutzungsobjekts.

### Aufgabe der Erfindung

Der Erfindung liegt die Aufgabe zu Grunde, ein System zur fokussierten Bereichsüberwachung zu schaffen, welches mindestens ein Benutzungsobjekt im Erkennungsbereich zuverlässig erkennt und dementsprechend nur dann ein Funktionsobjekt auslöst, nachdem die Erkennung des Benutzungsobjekts im Erkennungsbereich sichergestellt ist.

### Beschreibung der Erfindung

Die Lösung der Aufgabe der Erfindung erfolgt durch ein System zur Bereichsüberwachung gemäss Anspruch 1. Vorteilhafte Ausführungsbeispiele des Systems sind Gegenstand der Ansprüche 2 bis 15.

Wenn der Begriff "beispielsweise" in der nachfolgenden Beschreibung verwendet wird, bezieht sich dieser Begriff auf Ausführungsbeispiele und/oder Ausführungsformen, was nicht notwendigerweise als eine bevorzugtere Anwendung der Lehre der Erfindung zu verstehen ist. In ähnlicher Weise sind die Begriffe "vorzugsweise", "bevorzugt" zu verstehen, indem sie sich auf ein Beispiel aus einer Menge von Ausführungsbeispielen und/oder Ausführungsformen beziehen, was nicht notwendigerweise als eine bevorzugte Anwendung der Lehre der Erfindung zu verstehen ist. Dementsprechend können sich die Begriffe "beispielsweise", "vorzugsweise" oder "bevorzugt" auf eine Mehrzahl von Ausführungsbeispielen und/oder Ausführungsformen beziehen.

Die nachfolgende detaillierte Beschreibung enthält verschiedene Ausführungsbeispiele für das erfindungsgemässe System. Die Beschreibung eines bestimmten Systems ist nur als beispielhaft anzusehen. In der Beschreibung und den Ansprüchen werden die Begriffe "enthalten", "umfassen", "aufweisen" als "enthalten, aber nicht beschränkt auf" interpretiert.

In der nachfolgenden Beschreibung ist unter dem Begriff "AC" Wechselspannung, unter dem Begriff "DC" Gleichspannung, unter dem Begriff "PCB" Leiterplatte, unter dem Begriff "LED" Leuchtdiode, unter dem Begriff "OLED" organische Leuchtdiode, unter dem Begriff "LCD oder LCD Chip" ein elektrischer Chip als Flüssigkristalldurchlassanzeige mit kleinen, pixelmässigen Durchlassfiltern, unter dem Begriff "LCoS oder LCoS Chip" ein elektrischer Chip als Flüssigkristallreflexionsanzeige mit kleinen Reflexionspixeln, unter dem Begriff "DLP oder DLP Chip" ein elektrischer Chip mit kleinen, darauf angebrachten Spiegeln, unter dem Begriff "Needle Point" Kontaktflächen für Kontaktnadeln, unter dem Begriff "APP" zusätzliche Applikation für elektronische Geräte, unter dem Begriff "Remote Monitoring" Fernüberwachung, unter dem Begriff "Remote Recording" Fernaufzeichnung, unter dem Begriff "Remote Bugfixing" Fernfehlerbehebung und unter dem Begriff "Debugmodus" Fehlersuchmodus zu verstehen.

Ein System zur Bereichsüberwachung, umfassend ein berührungsloses Bedienungselement, umfassend mindestens einen berührungslosen Erkennungssensor oder eine entsprechende Schnittstelle, wobei der berührungslose Erkennungssensor oder die Schnittstelle zur Erkennung des Benutzungsobjekts ausgebildet ist, wenn sich das Benutzungsobjekt in einem Erkennungsbereich befindet, der durch mindestens eine Erkennungsbereichskennzeichnung gekennzeichnet ist.

Ein berührungsloses Bedienungselement kann für jegliche Human-Machine-Interface Anwendungen mit einfachen oder redundanten Einfach- oder Mehrfachschalter, -taster oder -dimmer als einfache oder mehrfache Ein/Aus- oder Wechsel- oder Kreuz- oder Serien- oder Kontrollschaltung eingesetzt werden und ergänzend zu konventionellen Schalter oder Tastern oder Dimmern oder stattdessen verwendet werden.

Das berührungslose Bedienungselement kann als Human-Machine-Interface für Funktionsobjekte beispielsweise in einem Gebäude, im Freien und in Fortbewegungsmitteln, beispielsweise Landfahrzeuge, Flugfahrzeuge und Wasserfahrzeuge, eingesetzt werden. Die Funktionsobjekte können beispielsweise Ansteuerungen, Maschinen, Geräte, Anlagen, Ampeln, Automaten, Licht, Fenster, Türen, Tore, Jalousien, Marquisen, Stören, Aufzüge, Anlagen, und Flüssigkeitsansteuerungen sein.

Insbesondere können die Ausgaben Informationen und Zustände weitergeben oder Funktionsobjekte, beispielsweise als Schaltauslöser oder Funktionsauslöser oder Zustandsauslöser oder Zugangsauslöser, und/oder deren Funktionen und/oder deren Ablaufprozeduren beispielsweise einschalten, aktiviert, deaktiviert, vorkonditioniert, nachkonditioniert, steuern, einstellen, schalten, toggeln oder dimmen werden. Als Ablaufprozeduren werden als zeitliche oder logische Kombinationen von Funktionen eines oder verschiedener Funktionsobjekte definiert.

Das berührungslose Bedienungselement kann ein System oder mehrere Teilsysteme, beispielsweise Sensorsender oder Sensorempfänger oder ein Erkennungsbereichskennzeichnungsgerät, umfassen, die einzeln beim oder entfernt vom Funktionsobjekt und/oder bündig-versenkt, teilversenkt oder auf einer Oberfläche, beispielsweise einer Wand, einem Boden oder einer Decke, angebracht sind.

Das berührungslose Bedienungselement kann mindestens einen berührungslosen Erkennungssensor oder eine entsprechende drahtgebundene oder drahtlose Eingangsschnittstelle umfassen. Der berührungslose Erkennungssensor kann einen fokussierten Erkennungsbereich für die Erkennung eines Benutzungsobjekts, beispielsweise Lebewesen oder Fortbewegungsmittel, überwachen. Der berührungslose Erkennungssensor kann somit als ein Überwachungssensor ausgebildet sein, der auf den Erkennungsbereich fokussiert ist. Der berührungslose Erkennungssensor kann auch genutzt werden, um eine vorhandene oder fehlende Präsenz eines Benutzungsobjektes, beispielsweise als Ganzes oder deren Teile, im Erkennungsbereich zu erkennen.

Normalerweise haben Erkennungssensoren, beispielsweise Bewegungssensoren oder Näherungssensoren oder Präsenzsensoren, einen weiten Erkennungsbereich mit einem Erkennungssensorwinkel von bis zu 110° und keine Erkennungsbereichskennzeichnung, da der Sensor den gesamten Winkelbereich und eine grossen Bereich für die Erkennung erfasst. Somit ist keine selektive Auslösung eines Funktionsobjekts und/oder deren Funktion oder deren Ablaufprozedur möglich. Der berührungslose Erkennungssensor hat hingegen einen deutlich reduzierten Erkennungsbereich, beispielsweise einen Durchmesser von beispielsweise bis zu 3 m oder einen Erkennungssensorwinkel von beispielsweise 60°, um eine selektive Auslösung zu ermöglichen.

Gemäss einem Ausführungsbeispiel kann die Erkennungsbereichskennzeichnung als eine feste Erkennungsbereichskennzeichnung ausgebildet sein und/oder die Erkennungsbereichskennzeichnung kann durch ein fokussiertes Erkennungsbereichskennzeichnungsgerät dargestellt werden.

Der Erkennungsbereich kann durch mindestens eine Erkennungsbereichskennzeichnung gekennzeichnet sein. Die Erkennungsbereichskennzeichnung kann als eine feste, beispielsweise ortsfeste und/oder gleichbleibende, Erkennungsbereichskennzeichnung ausgebildet sein und/oder alternativ oder ergänzend kann eine fokussierte Erkennungsbereichskennzeichnung durch ein fokussiertes Erkennungsbereichskennzeichnungsgerät dargestellt werden.

Das Erkennungsbereichskennzeichnungsgerät kann die Erkennungsbereichskennzeichnung beispielsweise durch Lichtabstrahlung, beispielsweise durch Lichtkontur oder Lichtspot oder Lichtmuster oder Leuchtfläche, und/oder durch Lichtreflexion, beispielsweise durch Lichtkontur oder Laser oder Lichtspot oder Lichtmuster oder Projektor oder Beamer, erzeugen.

Die Erkennungsbereichskennzeichnung kann den fokussierten Erkennungsbereich kennzeichnen und auf einer von der Befestigung des berührungslosen Bedienungselements unabhängigen Oberfläche, beispielsweise einer Wand, einem Boden oder einer Decke, markiert werden.

Gemäss einem Ausführungsbeispiel umfasst die Erkennungsbereichskennzeichnung eine Darstellung, die mindestens eine Darstellungsform und/oder Darstellungsinformation umfasst und über die Laufzeit gleichbleibend oder bei einer Erkennungsbereichskennzeichnung durch ein Erkennungsbereichskennzeichnungsgerät veränderlich ist.

Die feste Erkennungsbereichskennzeichnung kann beispielsweise die nachfolgend beschriebene Darstellung enthalten und/oder bündig oder erhaben oder vertieft auf der Oberfläche angebracht werden. Die Erkennungsbereichskennzeichnung des Erkennungsbereichskennzeichnungsgeräts umfasst die nachfolgend beschriebene Darstellung, die über die Laufzeit gleichbleibend oder veränderlich ist.

Die Darstellung der Erkennungsbereichskennzeichnung umfasst mindestens ein Element aus der Darstellungsform und/oder der Darstellungsinformation. Die Darstellungsform umfasst beispielsweise ein Element aus der Gruppe der Formen, Muster, Graustufen, Farbauswahl, Einfarbigkeit, Mehrfarbigkeit, Farbfolgen, Farbkombination, Orientierung, Helligkeit, Blinkfrequenz, Leuchtdauer, Ausschaltdauer. Die Darstellungsinformation umfasst beispielsweise ein Element aus der Gruppe der generellen Informationen, Informationen und/oder Zustände des berührungslosen Bedienungselementes und/oder des zugehörigen Funktionsobjekts, Richtungsanzeigen, Symbole, Logos, Zeichen, Schriften, Texte, Fehlercodes, gleichbleibenden oder sich änderndem Bilder, Videos. Die Darstellung kann beispielsweise für Informations- und/oder Zustandsdarstellung, Branding, Unterhaltung oder Werbung verwendet werden.

Gemäss einem Ausführungsbeispiel kann durch einen Zuordnungshinweis in der Darstellung der Erkennungsbereichskennzeichnung und/oder durch mindestens eine Zuordnungskennzeichnung das berührungslose Bedienungselement dem zugehörigen Funktionsobjekt und/oder deren Funktion und/oder deren Ablaufprozedur zuordenbar sein.

Die Zuordnungskennzeichnung kann auf oder beim Bedienungselement sein und kann mit der Darstellung auf das zugehörige Funktionsobjekt und/oder deren Funktion respektive Ablaufprozedur hinweisen. Alternativ kann eine identische oder mindestens ähnliche Darstellungen der Zuordnungskennzeichnungen auf oder beim berührungslosen Bedienungselement sowie auf oder beim Funktionsobjekt gekennzeichnet sein, um eine Zuordnung zwischen dem Bedienungselement und dem Funktionsobjekt insbesondere bei einer entfernten Anbringung zu ermöglichen. Die Darstellung des Zuordnungshinweises und/oder der Zuordnungskennzeichnung kann mindestens eine Darstellungsform und/oder Darstellungsinformation analog zur Darstellung der Erkennungsbereichskennzeichnung enthalten.

Gemäss einem Ausführungsbeispiel ist das berührungslose Bedienungselement mit mindestens einer Erkennungsbereichskennzeichnung für verschiedene Funktionsobjekte und/oder verschiedene Funktionen und/oder verschiedene Ablaufprozeduren verwendbar, indem das berührungslose Bedienungselement mehrere, unabhängige Erkennungen und/oder zeitlich wechselnde Erkennungen in der gleichen Erkennung umfasst.

In beiden Fällen kann ein Zuordnungshinweis und/oder eine Zuordnungskennzeichnung eine Zuordnung zu den verschiedene Funktionsobjekten und/oder deren Funktionen und/oder der Ablaufprozeduren ermöglichen.

Gemäss einem Ausführungsbeispiel umfasst das berührungslose Bedienungselement mindestens einen berührungslosen Vorerkennungssensor oder eine entsprechende Schnittstelle, wobei der berührungslose Vorerkennungssensor oder die Schnittstelle zur Erkennung des Benutzungsobjekts ausgebildet ist, wenn sich das Benutzungsobjekt in einem Vorerkennungsbereich befindet, der grösser als der Erkennungsbereich ist.

Das berührungslose Bedienungselement kann optional mindestens einen berührungslosen Vorerkennungssensor oder eine entsprechende drahtgebundene oder drahtlose Eingangsschnittstelle umfassen. Der berührungslose, weniger fokussierte Vorerkennungssensor kann einen Vorerkennungsbereich, der grösser als der Erkennungsbereich ist, für die Vorerkennung eines Benutzungsobjekts, beispielsweise Lebewesen oder Fortbewegungsmittel, überwachen. Der berührungslose Vorerkennungssensor kann somit als ein Überwachungssensor für den Vorerkennungsbereich ausgebildet sein. Der berührungslose Vorerkennungssensor kann auch genutzt werden, um eine vorhandene oder fehlende Präsenz eines Benutzungsobjektes, beispielsweise als Ganzes oder deren Teile, im Vorerkennungsbereich zu erkennen.

Die Vorerkennung kann genutzt werden, um das berührungslose Bedienungselement als Ganzes oder in Teilen erst zu aktivieren, wenn ein Benutzungsobjekt im Vorerkennungsbereich und noch entfernt vom Erkennungsbereich vorhanden ist. Bei einer fehlenden Präsenz einen Benutzungsobjektes im Vorerkennungsbereich kann beispielsweise die Intensität der Erkennungsbereichskennzeichnung reduziert oder ganz abgeschaltet werden, um Energie zu sparen.

Gemäss einem Ausführungsbeispiel umfassen der berührungslose Erkennungssensor und/oder der berührungslose Vorerkennungssensor einen gerichteten Empfänger und/oder einen gerichteten Sender für eine fokussierte Transmissions- oder Reflexions- oder Benutzungsobjektabstrahlungsmessung.

Der gerichtete Empfänger und optional der gerichtete Sender können in einem oder in zwei verschiedenen Teilsystemen verbaut sein. Der gerichtete Empfänger umfasst einen fokussierten Sensorempfänger und der gerichtete Sender kann einen fokussierten Sensorsender umfassen. Der gerichtete Empfänger und/oder der gerichtete Sender können Elemente aus der Gruppe aus Ausrichtungselementen, beispielsweise eine Röhre, insbesondere mit einer absorbierenden oder reflektierenden Innenschicht, Fokussierungseinheiten, beispielsweise eine Linse, umfassen.

Gemäss einem Ausführungsbeispiel umfassen der berührungslose Vorerkennungssensor und/oder der berührungslose Erkennungssensor und/oder die Schnittstellen mindestens je einen Sensor aus der Gruppe bestehend aus Bewegungssensoren, Näherungssensoren, Präsenzsensoren, Lichtschranken, Induktivsensoren, Induktionsschleifen, Ultraschall-, Kapazitivsensoren oder Drucksensoren, Lichtsensoren, Lichtschranken und Infrarotsensoren.

Die unterschiedlichen Sensoren können zur Erkennung von Lebewesen oder Fortbewegungsmittel genutzt werden. Aus Kosten-, Komplexitäts- und Robustheitsgründen kann auf eine Auswertung per Kamera verzichtet werden.

Die Schnittstelle entsprechend einem berührungslosen Vorerkennungssensor und/oder die Schnittstelle entsprechend einem berührungslosen Erkennungssensor können einzeln oder kombiniert sein. Im Speziellen kann können die beiden Informationen auch über eine generelle Schnittstelle übertragen werden.

Statt des berührungslosen Vorerkennungssensors und/oder des berührungslosen Erkennungssensors kann das berührungslose Bedienungselement eine Schnittstelle aufweisen, sodass ein externer und/oder bereits vorhandener Sensor und/oder eine Information und/oder ein Sensor eines anderen Systems eingebunden werden kann. Anstatt des Vorerkennungssensors kann beispielsweise eine Kopplung mit einem Bewegungsmelder eines automatischen Lichtsystems genutzt werden. Der berührungslose Vorerkennungssensor kann im Speziellen einen normaler Schalter und/oder eine Zeitschaltung oder Zeitschaltuhr und/oder einen zusätzlichen bedienungselementinternen oder bedienungselementexternen Sensor, beispielsweise einen Umgebungslichtsensor, umfassen.

Gemäss einem Ausführungsbeispiel umfasst das berührungslose Bedienungselement mindestens eine Ausgabe.

Die Eingänge können mindestens als Informationssignale, Einstellungs-, Konfigurations- und Steuerungssignale verwendet werden. Die Ausgangssignale können mindestens Informationen an beliebige Objekte weitergeben oder die Funktionsobjekte und/oder deren Funktionen und/oder Ablaufprozeduren ansteuern.

Gemäss einem Ausführungsbeispiel umfasst das berührungslose Bedienungselement mindestens eine Eingabe und/oder Ausgabe aus der Gruppe bestehend aus einem Ausgangsschaltmodul und/oder einem Kommunikationsmodul und/oder einer visuellen und/oder akustischen und/oder haptischen und/oder kommunikationstechnischen Eingabe und/oder Ausgabe und/oder einem Schaltmodul zur Veränderung der Erkennungsbereichskennzeichnung.

Die visuellen Ausgaben umfassen beispielsweise separate visuelle Ausgaben und/oder Ausgaben mittels der Erkennungsbereichskennzeichnungen des Erkennungsbereichskennzeichnungsgeräts. Die akustischen Ausgaben umfassen beispielsweise eine Sprach- oder Soundmodul. Die haptischen Ausgaben umfassen beispielsweise ein Vibrationsmodul. Die kommunikationstechnischen Ausgaben, umfassen beispielsweise ein Kommunikationsmodul. Die Schaltmodule können beispielsweise zur Beeinflussung einer oder mehrerer Erkennungsbereichskennzeichnungen genutzt werden. Insbesondere können alle Informationen zwischen einer Kommunikationseinheit, als Sender oder Empfänger des berührungslosen Bedienungselements, und einem Objektgerät, beispielsweise einem Mobilfunkgerät oder einem anderen System, fokussiert ausgetauscht werden.

Durch die Ausgabe kann eine Auswahl aus allen Informationen und/oder Zustände und/oder Daten und/oder Parameter und/oder Signale und/oder Variablen vom berührungslosen Bedienungselement und/oder vom Funktionsobjekt und/oder vom Benutzungsobjekt und/oder von anderen, lokalen oder dezentralen Systemen, an mindestens ein Funktionsobjekte und/oder mindestens ein Benutzungsobjekt oder eine Person und/oder mindestens ein anderes, lokales oder dezentrales System drahtgebunden oder drahtlos, ein- oder gegenseitige, im Speziellen auch fokussiert kommuniziert werden. Durch die einseitige und gegenseitige Kommunikation werden beispielsweise Remote Monitoring, Remote Recording und Remote Bugfixing ermöglicht.

Insbesondere kann das berührungslose Bedienungselement dem Benutzungsobjekt den eigenen Zustand und/oder den Zustand des Funktionsobjektes, wie beispielsweise einen Vorerkennungsgrad oder Erkennungsgrad oder die Restdauer bis zur Bereitstellung und/oder Deaktivierung des Funktionsobjektes, beispielsweise mit einer unterschiedlichen Erkennungsbereichskennzeichnung des Erkennungsbereichskennzeichnungsgeräts, beispielsweise mit Veränderungen oder Übergängen in der Darstellung, und/oder einer anderen Ausgaben mitteilen, was dem Benutzungsobjekt als Information dient, um beispielsweise festzustellen, ob das berührungslose Bedienungselement das Benutzungsobjekt vorerkennt und/oder erkennt, ob es aktiviert und/oder deaktiviert wird.

Gemäss einem Ausführungsbeispiel kann das berührungslose Bedienungselement mindestens durch eine Kommunikation und/oder ein Kommunikationsmodul und/oder eine Kommunikationseinheit und/oder ein Objektgerät sein Verhalten anzeigen und/oder in seinem Verhalten beeinflusst und/oder ausgelöst werden.

Beispielsweise kann eine Person mittels einer Funktion eines Objektgeräts mit drahtloser Kommunikation, beispielsweise ein Gerät mit Mobilfunk und/oder Wifi und/oder Bluetooth mit einer APP, offen oder passwortgeschützt drahtlos und nicht direkt am Gerät das Verhalten des berührungslosen Bedienungselements ansehen und/oder beeinflussen. Das Verhalten des berührungslosen Bedienungselements kann beispielsweise bezüglich Eingängen, Einstellungen, Algorithmen, Darstellungen und Ausgaben beeinflusst werden. Im Speziellen kann damit das berührungslose Bedienungselement als Ganzes und/oder die Vorerkennung und/oder die einzelnen Ausgaben und/oder die Erkennungsbereichskennzeichnung und/oder das Display einzeln eingeschaltet und/oder ausgeschaltet, der Erkennungs- und/oder Vorerkennungsalgorithmus durch Veränderung der Filter und Güteschwellen angepasst, das Schaltbefehlsmanagements und/oder das Zustandsmanagements beeinflusst, die Deaktivierungsdauer für die Erkennungsbereichskennzeichnung und die Ansteuerung des Funktionsobjektes verändert werden.
Zusätzlich kann das Benutzungsobjekt das berührungslose Bedienungselement auch mittels einer Funktion eines Objektgeräts mit drahtloser Kommunikation, beispielsweise ein Gerät mit Mobilfunk und/oder Wifi und/oder Bluetooth mit einer APP zur Bedienung, offen oder passwortgeschützt auslösen.

Gemäss einem Ausführungsbeispiel kann das berührungslose Bedienungselement mittels eines Schaltbefehlsmanagements und/oder eines Zustandsmanagements und/oder Zusatzinformationen den Schaltvorgang pro Funktionsobjekt einzeln steuern und/oder optimieren.

Der Schaltvorgang, beispielsweise der Ein- und/oder Ausschaltzeitpunkt, kann pro Funktionsobjekt einzeln gesteuert und/oder optimiert werden, wodurch eine Bereitstellung des Funktionsobjekts und/oder eine Bereitstellung einer Funktion des Funktionsobjekts und/oder eine Bereitstellung einer Ablaufprozedur des Funktionsobjekts beim Eintreffen des Benutzungsobjektes beim Funktionsobjekt erfolgt und eine anschliessende Deaktivierung des Funktionsobjekts nicht bereits erfolgt ist. Beispielsweise kann keine Türöffnung und/oder erneute Schliessung einer Tür erfolgen, bevor eine gehbehinderte oder langsame Person bei der Tür angekommen ist.

Optional können Zusatzinformationen im berührungslosen Bedienungselement konfiguriert sein oder per Kommunikation ans berührungslose Bedienungselement übertragen werden. Die Zusatzinformation kann beispielsweise die Distanz oder normale Bewegungsdauer vom Erkennungsbereich zum Funktionsobjekt und/oder die Verzögerungsdauer des Funktionsobjektes und/oder deren Funktion und/oder deren Ablaufprozedur vom Befehl bis zur Umsetzung des Befehls sein.

Mittels der folgenden Zusatzinformation des Benutzungsobjekts und/oder individuellen und/oder zugehörigkeitsmässigen Erkennung und/oder Fortbewegungsunterstützungserkennung kann das Schaltbefehlsmanagement den Schaltvorgang für das Funktionsobjekt individuell zeitlich managen und weiter optimieren, beispielsweise kann bei der Erkennung einer langsamen oder behinderten Person durch eine der Erkennungen mindestens eine Anpassung, beispielsweise eine längere oder spätere Aktivierung, gemacht werden.

Gemäss einem Ausführungsbeispiel ist für das berührungslose Bedienungselement, mittels des berührungslosen Erkennungssensors und/oder des berührungslosen Vorerkennungssensors und/oder der Schnittstellen und/oder mindestens eines Zusatzsensors mindestens eine Zusatzinformation des Benutzungsobjekts und/oder mindestens ein Umgebungseinfluss ermittelbar.

Als Umgebungseinflüsse können beispielsweise die Temperatur oder das Umgebungslicht oder das Infrarotlicht oder Geräusche gemessen werden. Die Messung von Umgebungseinflüssen können vom berührungslosen Bedienungselement beispielsweise für Anpassungen, Kompensationen, Fehlermeldungen oder Abschaltungen genutzt werden.

Beispielsweise kann durch eine Umgebungslichtmessung automatisch die Erkennungsbereichskennzeichnung ans Umgebungslicht anpasst werden, um die Sichtbarkeit der Erkennungsbereichskennzeichnung des Erkennungsbereichskennzeichnungsgeräts bei allen Umgebungslichtverhältnissen sicherzustellen.

Beispielsweise kann durch Umgebungsgeräuschmessung, beispielsweise mit dem Lautsprecher und/oder einem Mikrofon, automatisch die akustische Ausgabe an den Umgebungslärm angepasst werden. Damit kann sichergestellt werden, um die Hörbarkeit der akustischen Ausgabe, insbesondere für sehbehinderte Personen, bei allen Umgebungsgeräuschverhältnissen sicherzustellen.

Mittels einer Geschwindigkeits- und/oder Zeit-Messung für einen bestimmten Weg, beispielsweise durch den fokussierten, berührungslosen Erkennungssensor und/oder den berührungslosen Vorerkennungssensor und/oder mindestens einem weiteren, fokussierten Zusatzsensor mit unterschiedlichen und/oder unterschiedliche grossen Überwachungsbereichen, kann beispielsweise die Fortbewegungsgeschwindigkeit des Benutzungsobjekts bestimmt werden..

Gemäss einem Ausführungsbeispiel kann das berührungslose Bedienungselement mindestens einen Sensor aus der Gruppe bestehend aus einem Individualerkennungssensor und/oder einem Zugehörigkeitserkennungssensor und/oder einem Fortbewegungsunterstützungserkennungssensor umfassen.

Diese Erkennungssensoren ermöglichen eine individuelle und/oder zugehörigkeitsmässige Erkennung oder die Erkennung einer Fortbewegungsunterstützung. Das berührungslose Bedienungselement kann, beispielsweise im Vorerkennungsbereich oder Erkennungsbereich, an eine Benutzungsobjekterkennung, insbesondere eine Objekt- oder Personenerkennung, beispielsweise mittels Richtantenne oder RFID oder Mobilfunk oder Bluetooth oder WLAN oder Nummernschildererkennung oder an eine fokussierte Fortbewegungsunterstützungserkennung, beispielsweise durch Kapazitiv- oder Induktivsensoren oder Induktionsschleifen, direkt oder per Kommunikation angebunden werden. Bei der fokussierten Benutzungsobjekterkennung kann beispielsweise von einer Kommunikationseinheit, als Sender und Empfänger des berührungslosen Bedienungselements, ein Erkennungsmodul auch fokussiert erkannt werden.

Das berührungslose Bedienungselement kann alle Erkennungsinformation, beispielsweise die individuelle und/oder zugehörigkeitsmässige Erkennung und/oder die Benützung einer Fortbewegungsunterstützung und/oder Zusatzinformationen mindestens für eine der definierten Ausgaben genutzt werden, insbesondere für die individuelle Anpassung der Darstellung der Erkennungsbereichskennzeichnung des Erkennungsbereichskennzeichnungsgeräts. Zusätzlich können personenindividuelle Funktionen und/oder Ablaufprozeduren auf dem berührungslosen Bedienungselement und/oder den Funktionsobjekten freigeschaltet werden, insbesondere werden personenindividuelle und freigabenspezifische Ausprägungen und/oder Freigaben und/oder eine Informationsweitergabe, beispielsweise Freigabeanfragen und -erteilungen, und damit ein Freigabe- und/oder Zugangsmanagement und/oder Weitergabe der Informationen ermöglicht.

Sehbehinderte Personen können mit einem Sehbehindertenleitsystem auf dem Weg zum Funktionsobjekt zum und gleich weiter durch den Erkennungsbereich geführt werden.

Zusätzlich kann der Erkennungsbereich durch eine feste Erkennungsbereichsmarkierung analog zum Aufmerksamkeitsfeld im Sehbehindertenleitliniensystem mittels eines erhabenen oder vertieften Profils fest markiert werden. Das ermöglicht einer sehbehinderten Person den Erkennungsbereich zu finden und durch unterschiedliche Markierungen zu verstehen, wozu der Erkennungsbereich dient und was gemacht werden muss.

Wenn der berührungslose Erkennungssensor sich an einem berührbaren Ort, beispielsweise einer Wand, befindet, kann der berührungslose Erkennungssensor einen Erkennungsbereich bis zum berührbaren Ort haben, so dass sehbehinderte Personen den berührungslosen Erkennungssensor ertasten und durch eine Berührung auslösen können.

Gemäss einem Ausführungsbeispiel umfasst das berührungslose Bedienungselement mindestens ein einzelnes und/oder mindestens teilweise kombiniertes Element aus der Gruppe bestehend aus einer Grundplatte, einer Struktur, einer Rohrstruktur für eine Fokussierung, einer Verkleidung, einem Kühlungs- und/oder Entlüftungssystem, einer Seriennummer, einem Barcode, einem QR-Code, einem Befestigungselement.

Das berührungslose Bedienungselement umfasst mindestens eines der folgenden Module. Die folgenden Module können beliebig einzeln und/oder kombiniert aufgebaut sein. Die Module können fest und/oder durch Steckerverbindungen austauschbar für einen einfacheren Bauteilaustausch bei allfälligen Reparaturen verbunden werden. Die Module können separat oder auf dem zentralen PCB angebracht sein.

Das berührungslose Bedienungselement umfasst ein Versorgungsmodul und kann einen Wechselstromanschluss und/oder Gleichspannungsanschluss besitzen. Das Versorgungsmodul kann Stromsicherungen zur Absicherung, Schalter zum Schalten des ganzen Bedienungselements oder von Teilsystemen, beispielsweise Ein- und Aus- und Modischalten, Stecker, AC-AC oder AC/DC oder DC-DC Module zur Spannungsaufbereitung umfassen. Das Versorgungsmodul puffert, konvertiert und filtert Ein- und Ausgangsspannungen und stellt die Energieversorgung sicher und sichert das berührungslose Bedienungselement ab.

Das berührungslose Bedienungselement kann ein Erkennung-Sensormodul und optional ein Vorerkennung-Sensormodul und optional weitere Zusatzsensoren für die Eingangssignalerfassung, eine Umgebungsstörkompensation oder Datenaufzeichnung umfassen. Die Sensormodule für die Vorerkennung und/oder Erkennung und/oder Zusatzsensoren umfassen neben den Sensoren, einzeln einstellbare Sensorentprellungen, Mittelwertfilterungen und Hysteresengüteschaltungen, welche ein Tuning zwischen Erkennungsgüte, -sicherheit und Erkennungsgeschwindigkeit ermöglichen.

Das berührungslose Bedienungselement kann ein Ansteuerungsmodul, oder einen Stecker als Schnittstelle für das Modul, umfassen, die beispielsweise für die Freischaltung oder Einstellungen oder eine Auswahl beispielsweise von Funktionalitäten vorgesehen ist. Die Ansteuerung kann temporär oder bleibend weitere Funktionalitäten freischalten und/oder Einstellungen steuern und/oder eine Auswahl treffen.

Das berührungslose Bedienungselement kann ein I/O Modul, oder optional einen Stecker als Schnittstelle für das Modul, umfassen, das beispielsweise für Eingangs- und Ausgangssignalbereitstellung beispielsweise von Sensoren, externer Kommunikation, beispielsweise Eingangs- oder Ansteuerungssignalen und/oder externer Information, insbesondere Funktionsobjektinformation und/oder Einstellungen oder Konfiguration für das Bedienungselement oder andere Systeme umfassen. Das I/O Modul bereitet die Signale durch verschiedene Anpassungen, eine Filterung und Plausibilisierung zur Nutzung respektive Weitergabe auf. Zusätzlich beinhaltet das I/O Modul Switches, insbesondere DIP-Switches, womit Default- oder Testwerte von Ein-/Ausgängen, verschiedene Betriebs- und Kommunikationsmodi und Ein-/Ausgangsmodi beispielsweise ein Normalmodus, ein Testmodus oder ein Debugmodus oder eine Kommunikation für Ein- und Ausgangssignale eingestellt werden können. Das I/O Modul kann zusätzlich Messpunkte, insbesondere Needle Points enthalten.

Das berührungslose Bedienungselement umfasst ein Steuerungslogikmodul, womit mindestens ein Eingangssignal verarbeiten und mindestens ein Signal für einen Aktuator oder ein Ausgang bereitgestellt wird. Zudem kann das Steuerungslogikmodul das Zustandsmanagement, die optionale Schaltung für Vor- und Erkennung, den Pulsgenerator für das Blinken der Erkennungsbereichskennzeichnung, die individuelle Signal- und Schaltaufbereitung für die Ausgabe inklusive des optionalen Schaltbefehlsmanagements steuern. Die Signal- und Schaltaufbereitung umfasst beispielsweise eine Ein/Aus- oder Toggle- oder Dimm- oder Verzögerungsschaltung oder mindestens ein Ansteuerungsmodul oder eine Verstärkung für mindestens einen Ausgabeaktuator, wie beispielsweise Akustikmodul oder Vibrationsmodul und für die Schaltmodule.

Das berührungslose Bedienungselement kann eine separate visuelle Ausgabe und/oder AC-Schaltmodule oder DC-Schaltmodule für eine visuelle Ausgabe mit einem Erkennungsbereichskennzeichnungsgerät umfassen. Für ein AC Erkennungsbereichskennzeichnungsgerät kann beispielsweise ein Relais für eine AC-Lampe oder ein LED Chip oder ein Beamer vorgesehen sein. Für ein DC Erkennungsbereichskennzeichnungsgerät kann beispielsweise Relais für DC-Lampe oder LED Chip oder OLED Chip oder LED-Fliese oder LED-Ring, vorgesehen sein. Jedes der AC-Schaltmodule oder der DC-Schaltmodule kann mit thermischen Schutzelementen beispielsweise einem Thermal-Switch oder einer Temperatursicherung ausgestattet sein.

Das berührungslose Bedienungselement kann eine akustische Ausgabe, beispielsweise ein Sprach- oder Soundmodul mit einem Lautsprecher, und/oder eine haptische Ausgabe, beispielsweise ein Vibrationsmodul, und/oder ein Kommunikationsmodul für drahtgebundene oder drahtlose, ein- oder ausgehende Kommunikation umfassen. Das Kommunikationsmodul kann beispielsweise Information empfangen, entschlüsseln, verarbeiten, verschlüsseln, und/oder übertragen.

Das berührungslose Bedienungselement kann durch ein Eingangsschaltmodul oder ein Ausgangsschaltmodul oder ein Kommunikationsmodul mit Funktionsobjekten und/oder anderen Systemen und/oder Sensoren interagieren.

Jedes Schaltmodul kann mit einer Entkopplung, beispielsweise eine Schaltung oder ein Entkopplungselement, beispielsweise das berührungslose Bedienungselement in sich selbst und/oder von einem anderen System und/oder von einen Funktionsobjekt, beispielsweise durch einen potentialfreien Kontakt oder eine potentialfreies Relais, entkoppelt und sicher interagieren.

Das berührungslose Bedienungselement kann ein Logger-Anzeige Modul, oder einen Stecker als Schnittstelle für das Modul, umfassen, um beispielsweise eine beliebige Auswahl aus allen internen sowie externen Signalen und/oder Parametern und/oder Variablen und/oder Daten und/oder Informationen und/oder Zuständen parallel oder sequenziell zu erfassen und/oder zu speichern und/oder zu kommunizieren und/oder darzustellen. Beispielsweise können der Information zum Zustand des berührungslosen Bedienungselements und/oder der Funktionsobjektes, zu Eingangssignalen, zur Erkennung, optional zur Vorerkennung, zu Ausgaben beispielsweise mit deren Haltedauer, zur Darstellung beispielsweise Blinken, zu Fehlern beispielsweise Fehlercodes, zum Besetztzustand beispielsweise auf einer Anzeige oder auf einem Gerät mit Mobilfunk und/oder Wifi und/oder Bluetooth mit einer APP angezeigt werden.

Das berührungslose Bedienungsgerät kann nach allen mechanischen und elektrischen Aufbauten gemäss den Figuren mit beliebigen Erweiterungen oder Vereinfachungen aufgebaut sein.

Gemäss einem Ausführungsbeispiel umfasst das fokussierte Erkennungsbereichskennzeichnungsgerät ein Leuchtmittel und/oder mindestens ein Element aus der Gruppe bestehend aus einem Kühlungselement, einem Wärmeleitmaterial, einem thermischen Schutzelement, einem Filter, einer Linse und/oder Linsengruppe, einem Fokussierungsrohr oder Objektiv, einem Lichtbild, einem Ausrichtungsfilter, einem Überlagerungsmodul, einem Aufsplittungsmodul, einem Umlenkspiegel, einem elektronischen Durchlassfilter, einem Reflexionsfilter, einem rotierenden Farbrad und/oder Bildrad mit Antrieb und Ansteuerung.

Das fokussierte Erkennungsbereichskennzeichnungsgerät kann mit einer beliebigen Reihenfolge der beschriebenen Elemente und beispielsweise als Spot-Light aufgebaut sein. Das Erkennungsbereichskennzeichnungsgerät kann mindestens ein weisses oder bandbegrenztes Leuchtmittel enthalten, beispielsweise mindestens eine LED oder eine OLED oder einen LED Chip oder einen OLED Chip oder eine Lampe, um Licht zu erzeugen. Zur Kühlung des Leuchtmittels kann das Erkennungsbereichskennzeichnungsgerät ein Kühlungselement umfassen, das beispielsweise als ein Ventilator oder Kühlkörper, auch als Teil der Struktur, ausgebildet ist, welcher über ein Wärmeleitmaterial angebunden sein kann. Zur Verhinderung einer Zerstörung oder eines Brands kann das Erkennungsbereichskennzeichnungsgerät thermische Schutzelemente umfassen, beispielsweise ein Thermal-Switch oder eine Temperatursicherung bei den Schaltmodulen und/oder bei den Leuchtmitteln.

Das erzeugte Licht kann durch in beliebiger Reihenfolge angeordnete Linsen oder Linsengruppen fokussiert werden. Alternativ oder ergänzend kann das Licht mittels eines verstellbaren Fokussierungsrohrs, eines Objektivs, eines Filters, der beispielsweise als ein- oder mehrfacher Bandfilter für infrarotes Licht oder ultraviolettes Licht oder als ein Ausrichtungsfilter, beispielsweise eine Fresnell-Linse, ein rotierendes Farbrad und/oder ein Bildrad mit Antrieb und Ansteuerung ausgebildet ist, aufbereitet werden.

Die Grundfarben können hochfrequent sequenziell angezeigt oder durch Aufsplittungsmodule beispielsweise dichroitische Prismen und Umlenkspiegel und Überlagerungsmodule beispielsweise X-Prismen parallel bearbeitet und angezeigt werden. Die Darstellung kann mittels eines Farbfilters respektive Lichtbilds mit optionaler Darstellungsinformation optional auf einem oder zwischen zwei Gläsern optional mit Darstellungswechselvorrichtung oder durch einen elektronischen Durchlassfilter, beispielsweise LCD Chip oder durch einen elektronischen Reflexionsfilter, beispielsweise DLP oder LCoS Chip erzeugt werden.

Das Erkennungsbereichskennzeichnungsgerät kann Vorkehrungen beinhalten, die eine Fehlerkennung des berührungslosen Erkennungssensors durch den Einfluss der Erkennungsbereichskennzeichnung verhindern, beispielsweise ein Infrarotfilter, wenn es sich bei dem berührungslosen Erkennungssensor um einen Infrarotsensor handelt.

Das Erkennungsbereichskennzeichnungsgerät kann nach allen mechanischen und elektrischen Aufbauten gemäss den Figuren mit beliebigen Erweiterungen oder Vereinfachungen aufgebaut sein.

Das Zustandsmanagement kann beispielsweise harte oder fliessende Zustände umfassen, wobei die Zustände zumindest ein Element aus den nachfolgenden Zustandselementen enthalten können, einen Ausschaltzustand, einen Besetztzustand, einen Fehlerzustand, einen Wartezustand, ein Vorerkennungszustand, ein Erkennungszustand, einen Aktivierungszustand oder einen Deaktivierungszustand. Ausschliessende Zustände oder eine Zustandspriorität ermöglichen eine eindeutige Zustandsbestimmung und -darstellung.

Das Bedienungselement kann beispielsweise alle Informationen und/oder Zustände vorab, während und nach einer Zustandsveränderung insbesondere durch die Darstellung der Erkennungsbereichskennzeichnung und/oder einen Piepston und/oder eine Sprachansage und/oder eine Vibration und/oder eine Kommunikation von und zu einen Objektgerät, beispielsweise zu einem Mobilfunkgerät oder deren APP weitergeben. Beispielsweise kann der Grad der Zustandserkennung dem Benutzungsobjekt bei der Vorerkennung, Erkennung, Aktivierung und Deaktivierung durch den fliessenden Übergang abhängig von der Zustandssicherheit mitgeteilt werden.

Insbesondere kann der Zustand die Darstellung der Erkennungsbereichskennzeichnung des Erkennungsbereichskennzeichnungsgeräts angezeigt werden, wobei beispielsweise der Ausschaltungszustand und/oder Wartezustand und/oder Vorerkennungszustand beispielsweise durch verschiedene Intensitätsveränderungen und der Erkennungszustand und/oder Aktivierungszustand und/oder Deaktivierungszustand beispielsweise durchverschiedene Blinkfrequenzveränderungen angezeigt werden.

Die Ansteuerung des Funktionsobjektes mittels einer Bereichsüberwachung durch ein berührungsloses Bedienungselement kann beispielsweise folgenden Ablauf haben. Das Benutzungsobjekt bewegt sich auf ein Funktionsobjekt zu, das es gerne benützen möchte. Auf dem Weg zum Funktionsobjekt befindet sich das berührungslose Bedienungselement im Wartezustand, wenn es nicht optional durch eine Abschaltung im Ausschaltungszustand oder durch eine interne, externe oder kommunikative Fehlererkennung im Fehlerzustand oder durch eine anderweitige Benützung des Funktionsobjektes im Besetztzustand ist und das mit mindestens einer Ausgabe mitteilt. Das berührungslose Bedienungselement kann durch den Besetztzustand entweder temporär gesperrt sein oder nicht gesperrt sein und seine Aktivierung aktiv halten, bis das Funktionsobjekt die Aktivierung übernimmt. Im Wartezustand kann das berührungslose Bedienungselement teilweise, im Speziellen die Erkennungsbereichskennzeichnung des Erkennungsbereichskennzeichnungsgerätes, deaktiviert sein.

Wenn das berührungslose Bedienungselement den optionalen Vorerkennungssensor umfasst und wenn eine auch bewegte Präsenz des Benutzungsobjektes im Vorerkennungsbereich für eine gewisse minimale Güte und/oder Dauer durch den berührungslosen Vorerkennungssensor erkannt wird, wechselt das berührungslose Bedienungselement in den Vorerkennungszustand und das berührungslose Bedienungselement aktiviert sich, im Speziellen wird die Erkennungsbereichskennzeichnung des Erkennungsbereichskennzeichnungsgerätes aktiviert. Der markierte und fokussierte Erkennungsbereich des berührungslosen Bedienungselements befinden sich auf dem Weg zum Funktionsobjekt und wird durch eine feste Erkennungsbereichskennzeichnung oder die Erkennungsbereichskennzeichnung des Erkennungsbereichskennzeichnungsgerätes gekennzeichnet. Bei seiner kontinuierlichen, ununterbrochenen Bewegung zum Funktionsobjekt kann das Benutzungsobjekt mit der Durchquerung oder Umgehung des markierten und fokussierten Erkennungsbereiches des berührungslosen Bedienungselements derart bewusst steuern, um das Funktionsobjekt und/oder deren Funktion und/oder deren Ablaufprozedur zu aktivieren oder nicht zu aktivieren.

Wenn eine auch bewegte Präsenz des Benutzungsobjektes im Erkennungsbereich für eine minimale Güte und/oder Dauer durch den berührungslosen Erkennungssensor erkannt wird, wechselt das berührungslose Bedienungselement in den Erkennungszustand. Die Erkennung im Erkennungsbereich erfolgt durch Präsenz, beispielsweise auch in Bewegung und/oder ohne einen speziellen Ablauf und/oder ohne eine spezielle Handlung und/oder ohne eine spezielle Deutungsgeste und/oder ohne ein spezielles Körperteil des Benutzungsobjekts.

Bei einer ausreichenden Güte respektive Sicherheit und/oder Dauer der Erkennung wechselt das berührungslose Bedienungselement in den Aktivierungszustand. Die zunehmende Erkennung und/oder die eigene Aktivierung und/oder bei einer gegenseitigen Kommunikation mit dem Funktionsobjekt die Aktivierung und/oder Restdauer zur Bereitstellung und/oder Umsetzung des Funktionsobjekts werden dem Benutzungsobjekt und/oder Funktionsobjekt mit mindestens einer Ausgabe, beispielsweise mit einer Änderung in der Darstellung der Erkennungsbereichskennzeichnung des Erkennungsbereichskennzeichnungsgerätes während der Bewegung des Benutzungsobjekts angezeigt.

Das Benutzungsobjekt bewegt sich mit seiner kontinuierlichen, ununterbrochenen Bewegung weiter zum Funktionsobjekt, während der Wunsch des Benutzungsobjekts durch das aktivierte Funktionsobjekt und/oder deren aktivierte Funktion und/oder deren aktivierte Ablaufprozedur umsetzt wird und/oder durch optionales Schaltbefehlsmanagement zur Ankunft des Benutzungsobjekts am Funktionsobjekt zeitlich gemanagt wird.

Wenn eine Aktivierung in Ausführung und/oder ausgeführt und/oder abgeschlossen ist und kein weiteres Benutzungsobjekt in den Erkennungsbereich gekommen ist, wechselt das berührungslose Bedienungselement in den Deaktivierungszustand oder alternativ direkt in den Wartezustand. Im Speziellen kann vom Aktivierungszustand nach einer gewissen Aktivierungszeit und/oder nach einer Aktivierungsrücknahmeankündigung des Funktionsobjektes und/oder nach einer Erkennung von keiner Präsenz mit einer minimalen Sicherheit und/oder Dauer in den Deaktivierungszustand gewechselt werden, wenn eine optionale Mindesthaltezeit erreicht ist. Die Deaktivierung und damit indirekt die vorausgehende Aktivierung und/oder der Grad der Deaktivierung und/oder die Restdauer bis zur Deaktivierung wird optional dem auslösenden Benutzungsobjekt und/oder einem allfällig nachfolgenden Benutzungsobjekt und/oder Personen und/oder Funktionsobjekt mit mindestens einer Ausgabe angezeigt, beispielsweise mit einer Änderung in der Darstellung der Erkennungsbereichskennzeichnung des Erkennungsbereichskennzeichnungsgerätes.

Das berührungslose Bedienungselement wechselt in den Vorerkennungszustand zurück, wenn eine Deaktivierung in Ausführung und/oder ausgeführt und/oder abgeschlossen ist und kein weiteres Benutzungsobjekt in den Erkennungsbereich gekommen ist. Im Speziellen kann vom Deaktivierungszustand nach einer gewissen Deaktivierungszeit und/oder nach einer Aktivierungsrücknahmebestätigung durch das Funktionsobjekt und/oder nach einer Erkennung von keiner Präsenz mit einer ausreichenden Sicherheit und/oder Dauer in den Vorerkennungszustand gewechselt werden, wenn eine optionale Mindesthaltezeit erreicht ist. Wenn das berührungslose Bedienungselement den optionalen Vorerkennungssensor umfasst und im Vorerkennungszustand kein weiteres Benutzungsobjekt den Vorerkennungsbereich für eine gewisse Dauer und/oder für eine bestimmte Vorkennungsgüte durchquert, wechselt das berührungslosen Bedienungselements in den Wartezustand deaktiviert sich und/oder die Erkennungsbereichskennzeichnung des Erkennungsbereichskennzeichnungsgerätes.

Insbesondere werden die nachfolgenden Vorteile und Verbesserungen durch die Erfindung erzielt:
Ein berührungsloses Bedienungselement gemäss einem der Ausführungsbeispiele stellt eine für Behinderte, Senioren oder Fortbewegungsmittel taugliche Lösung dar, weil es die nachfolgenden Vorteile und Merkmale aufweist.

Durch den Entfall des genauen Auslösepunktes vereinfacht sich die Bedienung, da das Bedienungselement unabhängig von der Körpergrösse und Bewegungsradius und ohne komplizierte Bedienungselementbetätigung und ohne spezielle Geste und ohne Unterbrechung der Fortbewegung auslösbar ist und darum von körperlich behinderten Personen oder eingeschränkten Senioren komfortabel und problemlos bedient werden kann.

Die deutliche Erkennungsbereichskennzeichnung hilft seheingeschränkten Personen den Erkennungsbereich einfach zu finden. Zusätzlich kann der Erkennungsbereich oder das berührungslose Bedienungselement als Ganzes oder teilweise speziell im Erkennungsbereich mit einem zusätzlichen festen, starken Kontrast oder einem Kontrast durch abstrahlende oder reflektierende Beleuchtung hervorgehoben werden.

Sehbehinderte Personen können das Bedienungselement bedienen, indem sie mit gängigen Bodenmarkierungen im Speziellen mit einem Behinderten-Leitliniensystem zum oder durch den Erkennungsbereich oder zum Bedienungselement respektive Erkennungssensor und dann weiter zum entsprechenden Funktionsobjekt geführt werden.

Der Erkennungsbereich kann optional durch das normale Aufmerksamkeitsfeld oder durch eine feste, neuartige Erkennungsbereichsmarkierung gleich oder unterschiedlich nach Funktionsobjekt und/oder abhängig von der benötigten Aktion vertieft oder erhaben markiert werden. Es können auch verschiedene Erkennungsbereichsmarkierungen sein, abhängig davon ob und welche Aktion im Erkennungsbereich durchgeführt werden muss. Die neuartige Erkennungsbereichsmarkierung kann eine unterschiedliche Anzahl und Dicke von erhabenen oder vertieften Punkten, Linien und Abständen haben, die ein gut ertastbares Muster oder eine Figur, beispielsweise ein Kreis oder ein beliebig zur Laufrichtung gedrehtes Vieleck, beispielsweise ein Quadrat, bilden, vorteilhafterweise mit ausgefülltem oder unausgefülltem Mittenbereich.

Wenn der Erkennungsbereich am Boden ist, kann das Benutzungsobjekt, also insbesondere ein Behinderter, Senior oder ein Fortbewegungsmittel den Erkennungsbereich ohne spezielle Handlung einfach durchqueren, um die Funktion oder Ablaufprozedur zu aktivieren. Zudem könnte die Erkennungsbereichsmarkierung wahlweise entfallen, da ein Benutzungsobjekt auch durch eine andere Ausgabe, beispielsweise akustisch, informiert werden kann.

Wenn das berührungslose Bedienungselement sich beispielsweise an einem berührbaren Ort, beispielsweise einer Wand, befindet, kann das berührungslose Bedienungselement oder der berührungslose Erkennungssensor oder der Erkennungsbereich als Ganzes oder teilweise fühlbar sein, beispielsweise in einer abgehobenen oder vertieften Position zur umgebenden Oberfläche angeordnet werden. Zudem soll der berührungslose Erkennungssensor, der Vorerkennungssensor oder der Zusatzsensor einen Erkennungsbereich bis zu einer Berührungsstelle haben, so dass sehbehinderte Personen den Sensor auch per Berührung an der Berührungsstelle auslösen können.

Das berührungslose Bedienungselement und/oder der berührungslose Erkennungssensor und/oder der Vorerkennungssensor und/oder der Zusatzsensor kann als Ganzes oder teilweise beispielsweise der Erkennungsbereich mit einem starken farblichen Kontrast und/oder einem Kontrast durch abstrahlende oder reflektierende Beleuchtung hervorgehoben werden.

Das berührungslose Bedienungselement kann alle Zustände und Informationen, beispielsweise die Aktivierung und/oder die Deaktivierung und/oder den Vorerkennungsgrad und/oder den Erkennungsgrad mit mindestens einer Ausgabe, beispielsweise akustisch oder haptisch, auch fokussiert mitteilen, so dass die Kommunikation mit allen Behinderten sichergestellt ist.

Bei einer Erkennung einer langsamen oder behinderten Person kann das Bedienungselement und das dazugehörige Funktionsobjekt (9) angepasst werden.

Das System, insbesondere das berührungslose Bedienungselement bietet viele Möglichkeiten zur Produktsegmentierung respektive -individualisierung, beispielsweise Abmessung, Anbringungsort, Verbauvarianten, Design, Form, Farbe, Befestigungsmöglichkeit, Netzstecker und Netzspannungen, Anzahl Funktionsobjekte und/oder Funktionen und/oder Ablaufprozeduren, Vorerkennungssensorvarianten, Erkennungssensorvarianten, Erkennungsbereichskennzeichnungsvarianten inklusive Darstellung, Fokussierung und Profil, Zuordnungshinweise und -kennzeichnungen, Kühlung und thermische Schutzelemente, Kommunikationsvarianten inklusive Zuständen und Informationen, Eingangsvarianten, Ausgabevarianten inklusive Ausprägung und Deaktivierung, Umgebungsanpassungen, Schaltbefehlsmanagement, Benutzungsobjektsanpassung durch Zusatzinformation, Individual-, Zugehörigkeits-, Fortbewegungsunterstützungserkennung, Fernbedienung.

Wenn der berührungsloser Vorerkennungssensor im Vorerkennungsbereich keine Aktivität erkennt, kann die Erkennungsbereichskennzeichnung durch das Erkennungsbereichskennzeichnungsgerät zur Energieeinsparung reduziert oder ausgeschaltet werden, was die Energieeinsparung fördert, unnötige Wärmeentwicklung verhindert und die Lebensdauer des Systems verlängert.

Wenn eine Erkennung nur in einem fokussierten Erkennungsbereich erfolgt, ergeben sich wenig Fehlauslösungen durch sonstige Passanten und neue Einsatzmöglichkeiten, beispielsweise automatische WC-Türen mit Erkennungsbereich im Durchgang oder Bedienungen in Operationssälen. Zudem sind mehrere Funktionsauslösungen auf engem Raum platzierbar, beispielsweise mehrere Türe oder mehrere Fahrtrichtungen für einen Aufzug.

Die Erkennungsbereichskennzeichnung kann fest oder mit Erkennungsbereichskennzeichnungsgerät gezeichnet sein, wodurch der fokussierte Erkennungsbereich generell und auch von behinderten Personen einfach gefunden werden kann.

Die Darstellung der Erkennungsbereichskennzeichnung kann beispielsweise die Weitergabe von Zuständen und Informationen, eine feste oder zeitlich wechselnde Zuordnung zu einem Funktionsobjekt und/oder einer Funktion und/oder einer Ablaufprozedur, Branding, Unterhaltung oder Werbung an Benutzungsobjekte und andere Personen ermöglichen.

Das berührungslose Bedienungselement kann entfernt vom Funktionsobjekt angebracht werden, wodurch eine vorzeitige Auslösung des Funktionsobjekts möglich ist, was eine Reduktion der Wartezeit und gleichzeitig eine Einsatzbereitschaft des Funktionsobjektes beim Eintreffen des Benutzungsobjektes ermöglicht.

Das Zustandsmanagement des berührungslosen Bedienungselements ermöglicht einen klarer Ablauf und auch ein klare Weitergabe von Zuständen und Informationen an ein Benutzungsobjekt und/oder ein Funktionsobjekt und/oder andere Systeme.

Das berührungslose Bedienungselement kann mittels einer Umgebungsstörmessung und durch einer Kompensation, beispielsweise durch eine Sendeintensitätsanpassung oder eine hochfrequente Puls-Weiten-Modulation, an die Umgebungsstörung angepasst werden, womit die gewünschte Wahrnehmung auch bei Umgebungsstörungen sichergestellt wird.

Das berührungslose Bedienungselement muss für eine Bedienung nicht kontaktiert werden, sodass keine Verschmutzung einer Person und/oder des berührungslosen Bedienungselements erfolgen kann, sodass keine Kontamination und/oder keine Übertagung Person-Bedienungselement-Person erfolgen kann, insbesondere keine Übertragungsgefahr für Krankheitserreger und/oder Gifte besteht. Das System kann daher in Umgebungen eingesetzt werden, die erhöhten Hygieneanforderungen genügen müssen, beispielsweise in einem Reinraum oder einem Operationssaal.

Vorteilhafterweise ermöglicht das System eine gegenseitige, galvanische Trennung zwischen dem berührungslosen Bedienungselement und dem Benutzungsobjekt, was die Verletzungsgefahr beispielsweise durch einen Stromschlag reduziert und eine gegenseitige elektrische Potentialbeeinflussung verhindert.

Vorteilhafterweise enthält das System keine mechanisch bewegten Bauteile, wodurch die Verletzungsgefahr beispielsweise durch Einklemmen sinkt, weist somit eine weniger aufwendige Bauweise auf, ist geräuschlos, unterliegt keiner Abnutzung und kann demzufolge eine verlängerte Lebensdauer aufweisen.

Das berührungslose Bedienungselement kann Kühlmöglichkeiten und/oder Temperaturabsicherungen enthalten und teilweise in Brandschutzmaterial vergossen werden, sodass eine Überhitzung oder eine Entzündung oder ein Brand verhindert werden kann.

Das System kann zur Erkennung verschiedenster Benutzungsobjekte eingesetzt werden, insbesondere bewegbarer Benutzungsobjekte, beispielsweise Lebewesen, insbesondere Menschen oder Tiere, oder Fortbewegungsmittel.

Das System ermöglicht eine selektive Auswahl und ist einfach und in der normalen, ununterbrochenen Bewegung zum Funktionsobjekt bedienbar. Zudem erfordert das System keine spezielle und/oder gezielte Zusatzhandlung für Auslösung, insbesondere keine gezielte Handlung oder Gestik, beispielsweise eine Schalt- oder Kippbewegung oder eine Zeigegeste, und muss nicht durch ein spezifisches Teil, beispielsweise ein spezifisches Körperteil insbesondere Hand oder Fuss, ausgelöst werden. Die Bedienung ist im ganzen Erkennungsbereich möglich und nicht nur an einer kleinen, bestimmten Stelle, wodurch es einen grösseren, einfachen Bedienungsbereich gibt.

Das System ist insbesondere für behinderte oder eingeschränkte Personen oder Senioren geeignet, weil die Bedienung in der normalen Bewegung und einfach ohne Zusatzhandlung für Auslösung, insbesondere keine gezielte Handlung oder Gestik und ohne spezifisches Körperteil erfolgen kann. Das System ermöglicht eine einfache Bedienung unabhängig von der Körpergrösse und dem Bewegungsradius, wie bei Rollstuhlfahrern. Das System erfordert keine spezielle und/oder Handlung mit einem bestimmten Körperteil, beispielsweise keine Gestik mit Händen oder Füssen, was ein grosser Vorteil bei Behinderung oder der Verwendung von Gehhilfen ist.

Das berührungslose Bedienungselement kann, beispielsweise durch die Erkennungsbereichskennzeichnung, mit einem starken Kontrast deutlich markiert sein und ein Behindertenleitsystem kann vorhanden sein.

Das berührungslose Bedienungselement kann passiven Massnahmen, wie beispielsweise Kontrasten oder einem Behindertenleitsystem oder einer erhobenen oder vertiefte Position und/oder Profil, und/oder aktiven Massnahmen, beispielsweise optischen Signale, Geräusche, Vibration oder Wärme, zur Sicherstellung der Erkennung des Benutzungsobjekts umfassen, wodurch das berührungslose Bedienungselement von sehbehinderten oder seheingeschränkten Personen einfach aufgefunden werden kann.

Das berührungslose Bedienungselement durch eine durchgängige, davorliegende Oberfläche, beispielsweise einer Trennwand, bedient werden, wodurch die Benutzungsobjektumgebung in jeglicher möglichen Hinsicht, beispielsweise bezüglich Galvanik oder Temperatur oder Feuchtigkeit oder Luftdruck oder Hygiene oder Kontaminierung, von der Bedienungselementumgebung isoliert sein kann.

Das berührungslose Bedienungselement kann durch bestimmtes Material, insbesondere eine licht-teildurchlässige Isolierung, hindurch schalten. Das berührungslose Bedienungselement kann ausserhalb Betätigungsortes angebracht werden und kann damit beispielsweise es für Manipulationen unzugänglich gemacht werden. Es ist keine Einbettung in die Oberfläche notwendig, da das berührungslose Bedienungselement auch hinter der Oberfläche angebracht werden kann.

Das System weist einstellbare Schaltbedingung durch eine Obergüteschwelle oder Untergüteschwelle und eine Lerngeschwindigkeit auf, wodurch eine einfache Gewichtung zwischen Schaltschnelligkeit und -sicherheit erzielbar ist.

Das System eignet sich zur Verwendung von einfachen Leuchtmitteln, beispielsweise LED, OLED oder LED Chips oder OLED Chips, wodurch das berührungslose Bedienungselement energiesparend und kostengünstig gebaut werden kann. Bei einfachen Leuchtmitteln mit direktem Wechselspannungsanschluss können das Leuchtmittel und der Gleichrichter bei einem Defekt einfach ausgetauscht werden.

Das System zeichnet sich durch die Verwendung von einfachen Sensoren ohne Kamera aus, wodurch eine einfache, robuste, sichere, zuverlässige Erkennung ermöglicht wird und gleichzeitig einen kostengünstigen Aufbau des berührungslosen Bedienungselements ermöglicht.

Das berührungslose Bedienungselement kann mehrfach und verschieden kombiniert werden, sodass einfache, mehrfache und/oder redundante Aufbauten möglich sind. Es sind beliebige Multibedienungselementtypen, beispielsweise Schalter oder Taster oder Dimmer für einfache oder mehrfache Ein/Aus- oder Wechsel- oder Kreuz- oder Serien- oder Kontrollschaltung darstellbar.

### Kurzbeschreibuna der Zeichnungen

Nachfolgend wird das erfindungsgemässe System anhand einiger Ausführungsbeispiele dargestellt. Es zeigen
Fig. 0: ein berührungsloses Bedienungselement für ein Lebewesen nach einem ersten Ausführungsbeispiel,
Fig. 1: ein erweitertes berührungsloses Bedienungselement für ein Lebewesen nach einem zweiten Ausführungsbeispiel,
Fig. 2: ein erweitertes berührungsloses Bedienungselement für ein Fortbewegungsmittel,
Fig. 3: ein erweitertes berührungsloses Bedienungselement für ein Lebewesen im Speziellen einen Rollstuhlfahrer,
Fig. 4: Anbringungsarten des berührungslosen Bedienungselements,
Fig. 5: Aufbaumöglichkeiten für eine Erkennungsbereichskennzeichnung auf dem Boden,
Fig. 6: Aufbaumöglichkeiten für eine Erkennungsbereichskennzeichnung auf der Wand,
Fig. 7: Aufbaumöglichkeiten für eine Erkennungsbereichskennzeichnung an der Decke,
Fig. 8a und Fig. 8b Querschnittsdarstellungen für einen hohen Bedienungselementaufbau,
Fig. 9 a und Fig. 9b Querschnittsdarstellungen für einen breiten Bedienungselementaufbau,
Fig. 10: einen Aufbau eines gerichteten Erkennungssensors mit Transmissionsmessung oder Reflexionsmessung oder Benutzungsobjektabstrahlungsmessung,
Fig. 11: ein erstes Ausführungsbeispiel eines Erkennungsbereichskennzeichnungsgeräts als einfacher, einfarbiger Spot,
Fig. 12: ein zweites Ausführungsbeispiel eines Erkennungsbereichskennzeichnungsgeräts als einfarbiger Spot mit Durchlassfilter,
Fig. 13: ein drittes Ausführungsbeispiel eines Erkennungsbereichskennzeichnungsgeräts als einfach oder mit Durchlassfilter aufgebauten, mehrfarbiger Spot mit Farbrad und/oder Bildrad,
Fig. 14: ein viertes Ausführungsbeispiel eines Erkennungsbereichskennzeichnungsgeräts als einfach oder mit Durchlassfilter aufgebauten, mehrfarbiger Spot,
Fig. 15: ein fünftes Ausführungsbeispiel eines Erkennungsbereichskennzeichnungsgeräts als einfach oder mit Durchlassfilter aufgebauten, mehrfarbiger Spot mit mehreren Leuchtmitteln,
Fig. 16: ein sechstes Ausführungsbeispiel eines Erkennungsbereichskennzeichnungsgeräts als einfarbiger Spot mit Reflexionsfilter,
Fig. 17: ein siebentes Ausführungsbeispiel eines Erkennungsbereichskennzeichnungsgeräts als mehrfarbiger Spot mit Reflexionsfilter und Farbrad und/oder Bildrad,
Fig. 18: ein achtes Ausführungsbeispiel eines Erkennungsbereichskennzeichnungsgeräts als mehrfarbiger Spot mit Reflexionsfilter,
Fig. 19: ein neuntes Ausführungsbeispiel eines Erkennungsbereichskennzeichnungsgeräts als mehrfarbiger Spot mit Reflexionsfilter mit mehreren Leuchtmitteln,
Fig. 20: einen einfachen Systemaufbau ohne Gleichspannungslogik nach einem ersten Ausführungsbeispiel,
Fig. 21: einen einfachen Systemaufbau ohne Gleichspannungslogik nach einem zweiten Ausführungsbeispiel,
Fig. 22: einen Systemaufbau mit Gleichspannungslogik,
Fig. 23: Erkennungsbereichsmarkierungen für Sehbehinderte mit Symbolplatzhalter,
Fig. 24: Erkennungsbereichsmarkierungen für Sehbehinderte anstatt Symbolplatzhalter,
Fig. 25: ein erweitertes berührungsloses Bedienungselement für ein Lebewesen nach einem weiteren Ausführungsbeispiel.

### Detaillierte Beschreibung der Zeichnungen

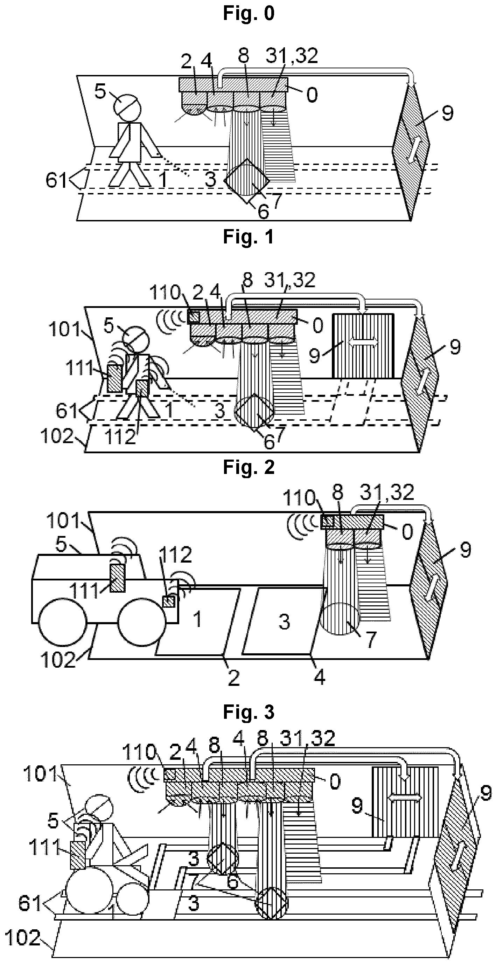

Die Figuren 0 bis 3 und 25 zeigen das berührungslose Bedienungselement 0 mit verschiedenen Benutzungsobjekten 5 und in verschiedenen Ausführungsvarianten. Das Benutzungsobjekt 5 kann das Bedienungselement 0 idealerweise in seiner ununterbrochenen Bewegung zum Funktionsobjekt 9 und/oder ohne spezielle Handlungen und/oder ohne spezielle Geste und/oder ohne spezielles Körperteil auslösen. Beispielsweise kann der Erkennungsbereich 3 am rechten oder linken Rande des Ganges sein, dann kann das Funktionsobjekt 9 durch einen Weg am Rande durch den Erkennungsbereich 3 das Funktionsobjekt auslösen, respektive durch Vorbeibewegen nicht am Rand nicht auslösen. Das Benutzungsobjekt 5 kann seine Bewegung zum Funktionsobjekt 9 bis auf einen minimal anderen Weg normal und ohne Unterbruch durchführen.

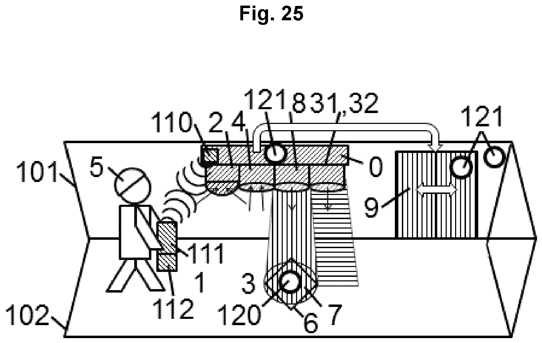

Das berührungslose Bedienungselement 0 kann beim oder vom Funktionsobjekt 9 entfernt angebracht sein, wobei gemäss Figur 25 ein Zuordnungshinweis 120 in der Darstellung der Erkennungsbereichskennzeichnung 6, 7 oder eine Zuordnungskennzeichnung 121 eine Zuordnung vom berührungslosen Bedienungselement 0 zu verschiedenen Funktionsobjekten 9 und/oder deren Funktionen respektive Ablaufprozeduren erlaubt.

Das berührungslose Bedienungselement 0 kann eine feste Erkennungsbereichskennzeichnung 6 und/oder eine Erkennungsbereichskennzeichnung 7 durch ein Erkennungsbereichskennzeichnungsgerät 8 aufweisen, die den Erkennungsbereich kennzeichnet. Die Erkennungsbereichskennzeichnung 7 kann zusätzlich genutzt werden, um mit dem und/oder nachfolgenden Benutzungsobjekten 5 oder anderen Personen über verschiedene Darstellungen zu kommunizieren.

Bei fehlender Präsenz und ohne Degradation befindet sich das berührungslose Bedienungselement 0 im Wartezustand. Um Energie zu sparen, kann die optionale Erkennungsbereichskennzeichnung 7 durch das Erkennungsbereichskennzeichnungsgerät 8 nicht voll ausgeprägt, beispielsweise ausgeschaltet oder mit geringer Intensität beleuchtet sein.

Erst wenn ein Benutzungsobjekt 5 in den grossen Vorerkennungsbereich 1 kommt, respektive sich darin befindet, kann es vom optionalen, berührungslosen Vorerkennungssensor 2 für die Vorerkennung erkannt werden. Wenn die Vorerkennung respektive Vorerkennungsdauer eine bestimmte Güte übersteigt, wechselt das berührungslose Bedienungselement 0 in den Vorerkennungszustand und die fokussierte Erkennungsbereichskennzeichnung 7 kann durch das Erkennungsbereichskennzeichnungsgerät 8 voll ausgeprägt dargestellt werden.

Nun ist der fokussierte Erkennungsbereich 3 für das Benutzungsobjekt 5 ersichtlich. Das Benutzungsobjekt 5 kann sich nun ohne Anhalten und/oder ohne spezielle Handlung und/oder ohne Gesten, beispielsweise mit Hand oder Fuss, bei Bedarf bezüglich des zugehörigen Funktionsobjekts 9 durch den gekennzeichneten Erkennungsbereich 3 oder sonst daran vorbeibewegen. Zusätzlich oder alternativ kann der Erkennungsbereich auch durch eine feste Erkennungsbereichskennzeichnung 6 vertieft, eben oder erhaben markiert sein und/oder zusätzlich kann ein Sehbehindertenleitsystem 61 zum Erkennungsbereich 3 und dann zum Funktionsobjekt 9 führen, was beispielsweise seheingeschränkten und sehbehinderten Personen ermöglicht den Erkennungsbereich 3 zu finden und erkennen. Wenn sich das Benutzungsobjekt 5 bewusst in den Erkennungsbereich 3 bewegt, wird es vom berührungslosen, fokussierten Erkennungssensor 4 erkannt und das berührungslose Bedienungselement 0 wechselt in den Erkennungszustand. Wenn die Erkennung respektive Erkennungsdauer eine bestimmte Güte übersteigt, wechselt das berührungslose Bedienungselement 0 in den Aktivierungszustand.

Wenn das auslösende respektive das letzte Benutzungsobjekt 5 den Erkennungsbereich 3 für eine bestimmte Zeit verlassen haben und/oder die Erkennung eine bestimmte Güte unterschreitet, wechselt das berührungslose Bedienungselement 0 in den Deaktivierungszustand.

Wenn kein Benutzungsobjekt 5 im Erkennungsbereich 3 und Vorerkennungsbereich 1 für eine bestimmte Zeit vorhanden ist und/oder die Vorerkennung und/oder Erkennung eine bestimmte Güte unterschreitet, wechselt das berührungslose Bedienungselement 0 in den Wartezustand.

Mindestens eine Information aus Wartezustand, Vorerkennungsgrad respektive Vorerkennung, Erkennungsgrad respektive Erkennung, Aktivierungszustand, Restdauer bis zur Bereitstellung und/oder Deaktivierung des Funktionsobjektes 9, Deaktivierungsgrad respektive Deaktivierung kann dem Funktionsobjekt 9 und/oder deren Funktion und/oder deren Ablaufprozedur für die Funktionsanpassung, Funktionsschaltung oder Funktionsauslösung auch entkoppelt kommuniziert und einem Benutzungsobjekt 5 oder anderen Personen oder anderen Systemen über mindestens eine Ausgabe auch fokussiert mitgeteilt werden. Die Mitteilung kann durch visuelle Ausgaben und/oder akustische Ausgaben mittels eines Sprach- oder Soundmoduls 31 und/oder haptische Ausgaben mittels eines Vibrationsmoduls 32 und/oder kommunikationstechnische Eingaben und Ausgaben mittels eines Kommunikationsmoduls 33 auch fokussiert kommuniziert werden. Insbesondere kann die kommunikationstechnische Eingabe und Ausgabe 33 durch eine Kommunikation über eine Kommunikationseinheit 110 von und zu einem Objektgerät 111 im Speziellen von und an ein Mobilfunkgerät realisiert werden. Insbesondere kann die visuelle Ausgabe durch die Erkennungsbereichskennzeichnung 7 des Erkennungsbereichskennzeichnungsgeräts 8 mittels eines AC-Schaltmoduls 29 oder eines DC-Schaltmoduls 30 realisiert werden.

Für unterschiedliche Funktionsobjekte 9 und/oder Funktionen und/oder Ablaufprozeduren können verschiedene berührungslose Bedienungselemente 0 und/oder gemäss Figur 3 das gleiche berührungslose Bedienungselement 0 mit mehreren, einzelnen Erkennungen und/oder gemäss Figur 1 zeitlich wechselnden respektive alternierenden Erkennungen in der gleichen Erkennung verwendet werden, wobei das aktuelle Funktionsobjekt 9 dem Benutzungsobjekt 5 über eine der genannten Ausgaben oder eine Zuordnung 120, 121 mitgeteilt werden kann. Insbesondere kann die Erkennungsbereichskennzeichnung 7 des Erkennungsbereichskennzeichnungsgeräts 8 in der Darstellung einen Zuordnungshinweis 120 enthalten.

Das berührungslose Bedienungselement 0 kann optional einen Individualerkennungssensor und/oder Zugehörigkeitserkennungssensor und/oder Fortbewegungsunterstützungserkennungssensor umfassen, wodurch eine individuelle und/oder zugehörigkeitsmässige Erkennung ermöglicht wird oder die Benützung einer Fortbewegungsunterstützung mittels eines fokussierten Erkennungsmoduls 112 erkannt wird.

Gemäss Figur 25 kann das berührungslose Bedienungselement 0 mindestens durch eine Kommunikation und/oder ein Kommunikationsmodul 33 und/oder eine Kommunikationseinheit 110 und/oder ein Objektgerät 111 sein Verhalten anzeigen und/oder in seinem Verhalten beeinflusst und/oder ausgelöst werden. Beispielsweise kann eine Person mittels einer Funktion eines Objektgeräts 111 mit drahtloser Kommunikation, beispielsweise ein Gerät mit Mobilfunk und/oder Wifi und/oder Bluetooth mit einer APP, das Verhalten des berührungslosen Bedienungselements 0 anzeigen und/oder beeinflussen. Zusätzlich kann das Benutzungsobjekt 5 das berührungslose Bedienungselement 0 auch mittels einer Funktion eines Objektgeräts 111 mit drahtloser Kommunikation, beispielsweise ein Gerät mit Mobilfunk und/oder Wifi und/oder Bluetooth mit einer APP zur Bedienung, auslösen.

Die Figur 4 zeigt die verschiedenen Anbringungsarten des berührungslosen Bedienungselements 0, beispielsweise aufgesetzt, teilversenkt oder bündig versenkt zur Oberfläche. Das berührungslose Bedienungselement 0 kann beispielsweise auf einer Decke 100 oder einer Wand 101 oder einem Boden 102 angebracht werden.

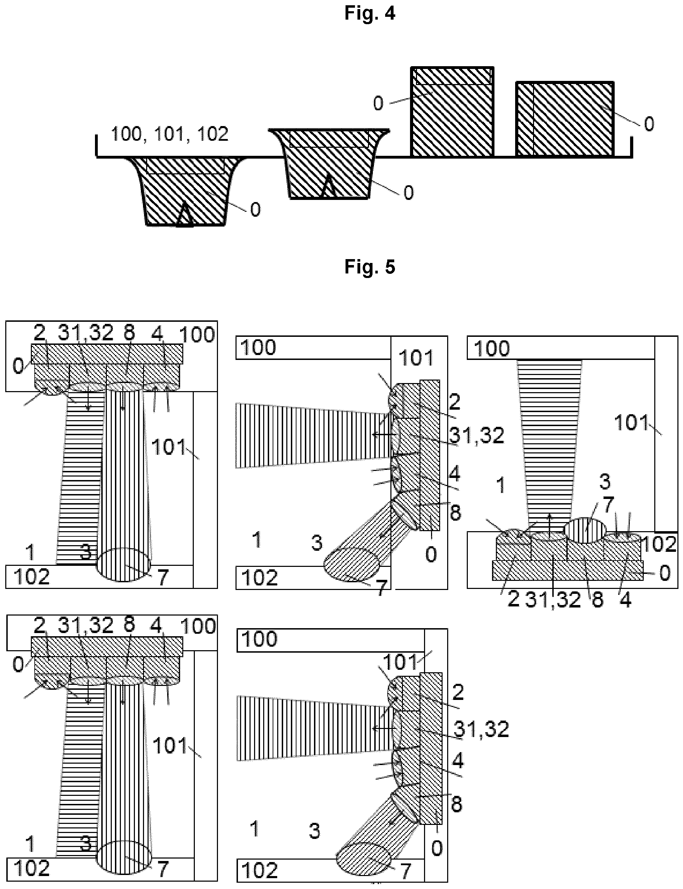

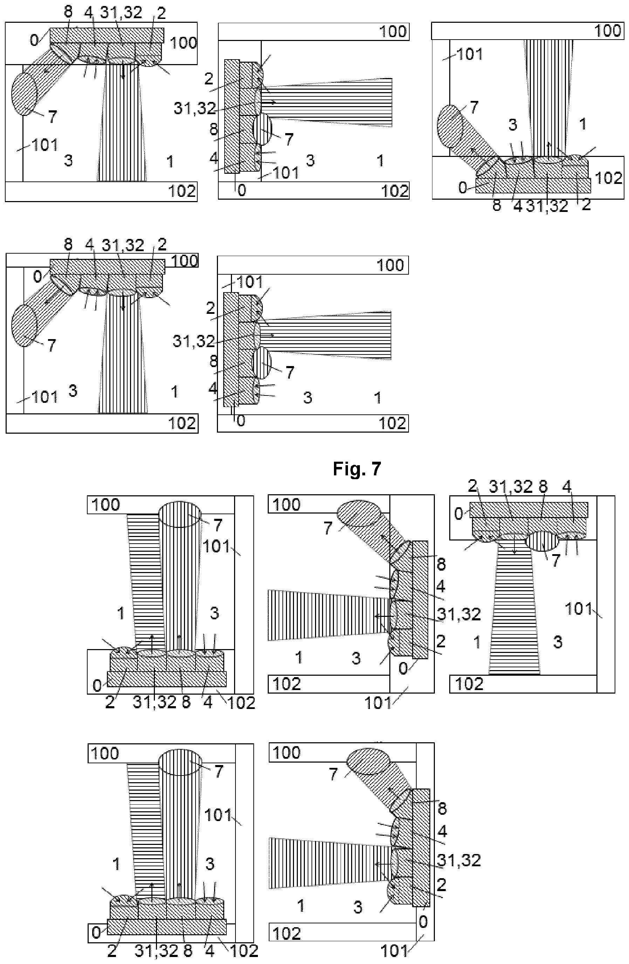

Die Figuren 5 bis 7 zeigen verschiedene Realisierungsprinzipien des berührungslosen Bedienungselements 0. Die Figuren unterscheiden sich bezüglich unterschiedlicher Oberflächen, auf denen das berührungslose Bedienungselement 0 befestigt wird und der Erkennungsbereich 3 sein kann. Das berührungslose Bedienungselement 0 kann mit allen seinen Komponenten auf beliebigen Oberflächen, beispielsweise einer Decke 100 oder einer Wand 101 oder einem Boden 102, angebracht sein. Der Erkennungsbereich 3 respektive die Erkennungsbereichskennzeichnung 6, 7 kann auf beliebigen, vom Anbringungsort unabhängigen Oberflächen, beispielsweise der Decke 100 oder der Wand 101 oder dem Boden 102, angebracht sein. Wenn das berührungslose Bedienungselement 0 und die Erkennungsbereichskennzeichnung 7 auf der gleichen Oberfläche sind, wird die Erkennungsbereichskennzeichnung 7 mittels Abstrahlung und sonst mittels Reflexion dargestellt.

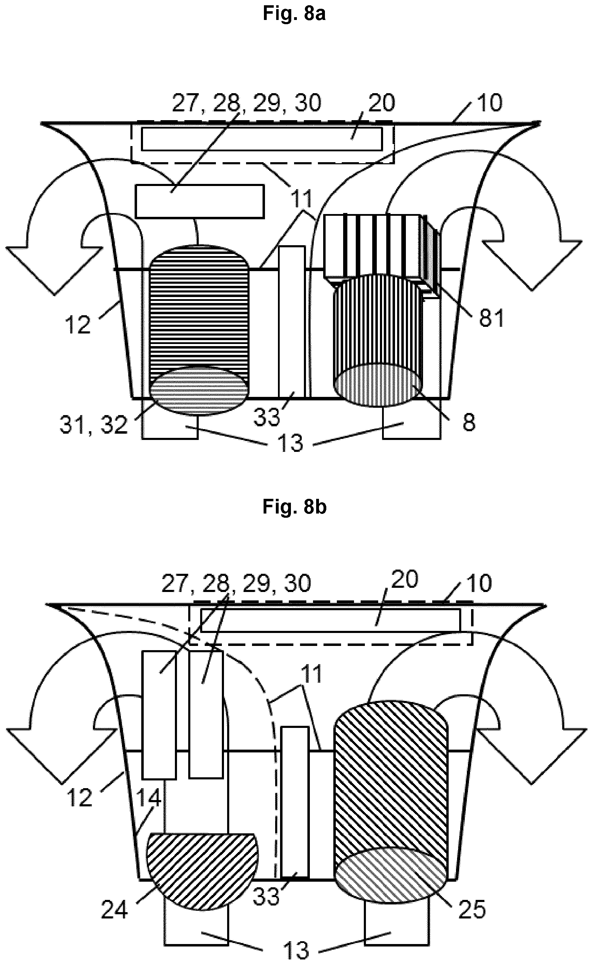

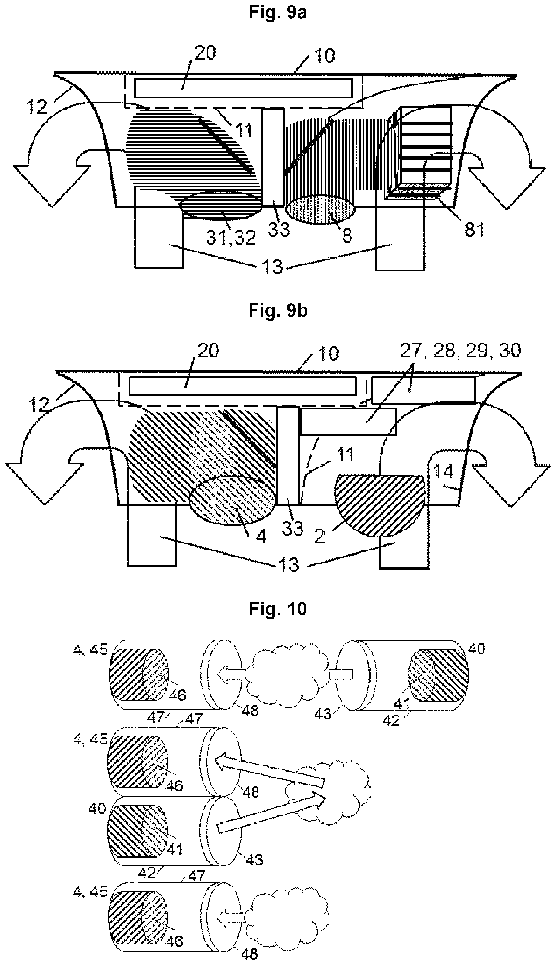

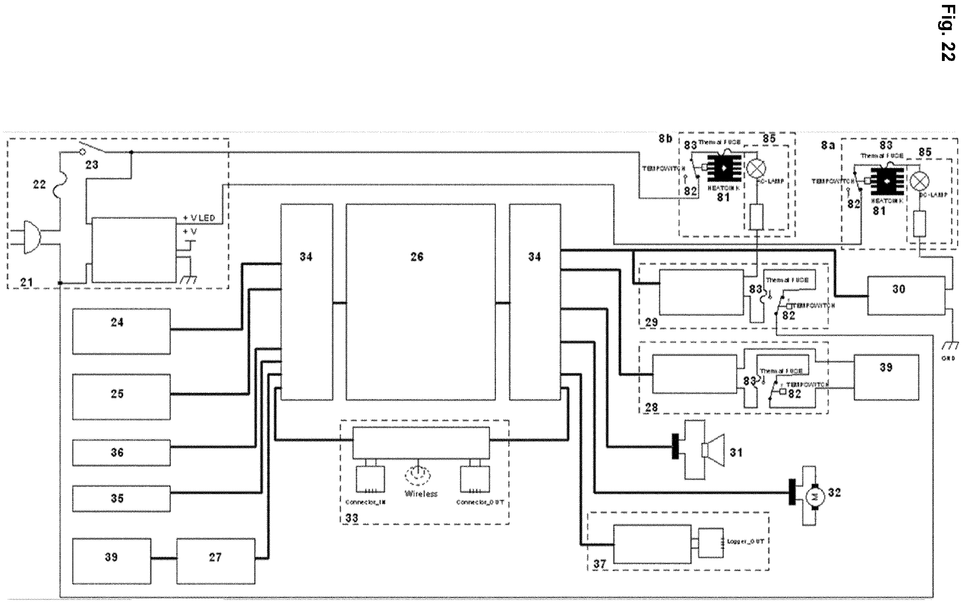

Die Figuren 8a, 8b sowie die Fig. 9a, 9b zeigen Querschnitte durch verschiedene Aufbauvarianten des berührungslosen Bedienungselements 0. In Figuren 8a, 8b sind höhere, schmälere Aufbauvarianten gezeigt, bei welchen die Informationen gradlinig übertragen werden. In Figuren 9a, 9b sind niedrigere, breitere Aufbauvarianten gezeigt, bei welchen die Informationen nicht gradlinig, sondern gebogen oder gekrümmt, respektive gespiegelt übertragen werden. Das Gehäuse des berührungslosen Bedienungselements 0 umfasst mindestens ein einzelnes und/oder kombiniertes Element aus der Gruppe bestehend aus einer Grundplatte 10 mit einem Befestigungssystem, einem Befestigungselement (15), einer Verkleidung 12, einer Struktur 11 und einer Rohrstruktur für eine Fokussierung 16 beide für die Befestigung der Komponenten und Module, beispielsweise umfassend Optik, einen PCB 20, ein Versorgungsmodul 21, ein fokussiertes Erkennungsbereichskennzeichnungsgerät 8 mit optionalem Kühlungselement 81, das beispielsweise ein Teil der Struktur sein kann, ein Vorerkennung-Sensormodul 24, mindestens umfassend den berührungslosen Vorerkennungssensor 2, ein Erkennung-Sensormodul 25, mindestens umfassend den berührungslosen Erkennungssensor 4, Schaltmodule respektive Relais 27 bis 30 für Eingänge und Ausgänge, eine akustische Ausgabe 31, beispielsweise ein Lausprecher, und eine haptische Ausgabe 32, beispielsweise ein Vibrationsmodul, eine kommunikationstechnische Eingaben und Ausgaben beispielsweise mittels eines Kommunikationsmoduls 33. Optional besitzt das Bedienungselement 0 ein passives oder aktives Kühlungs- und/oder Entlüftungssystem 13 und eine Seriennummer und/oder einen Barcode und/oder QR-Code 14. Im Gehäuse des berührungslosen Bedienungselements 0 können mindestens alle Module und Komponenten gemäss Figur 22 untergebracht werden.

Figur 10 zeigt Aufbaumöglichkeiten für den berührungslosen, fokussierten Erkennungssensor 4. Der Erkennungssensor 4 besteht einem gerichteten Empfänger 45, der zu einem Sender mit einem gerichteten Sensorempfänger 46 gegenüberliegend für eine Transmissionsmessung oder gleichseitig für eine Reflexionsmessung angeordnet ist, einer optionalen Empfänger-Ausrichtungsmöglichkeit 47 beispielsweise mit einer Röhre, insbesondere mit einer absorbierenden oder reflektierenden Innenschicht und einer optionalen Empfänger-Fokussierungsmöglichkeit 48, die beispielsweise mindestens eine optionale Linse enthält. Der Erkennungssensor 4 kann zusätzlich aus einem optionalen, gerichteten Sender 40 bestehen, der gegenüberliegend zum Empfänger für Transmissionsmessung oder gleichseitig für eine Reflexionsmessung angeordnet ist, mit einem gerichteten Sensorsender 41, einer optionalen Sender-Ausrichtungsmöglichkeit 42, beispielsweise mit einer Röhre, insbesondere mit einer absorbierenden oder reflektierenden Innenschicht und einer optionalen Sender-Fokussierungsmöglichkeit 43, die beispielsweise mindestens eine optionale Linse enthält.

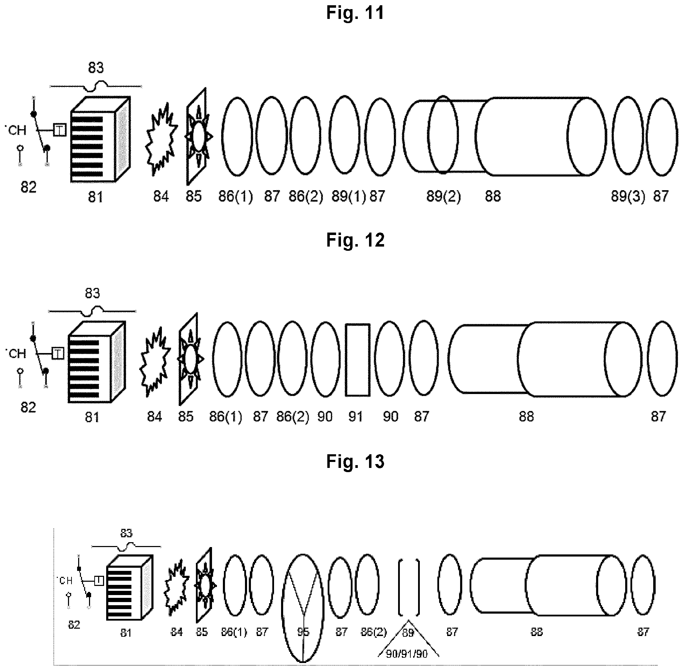

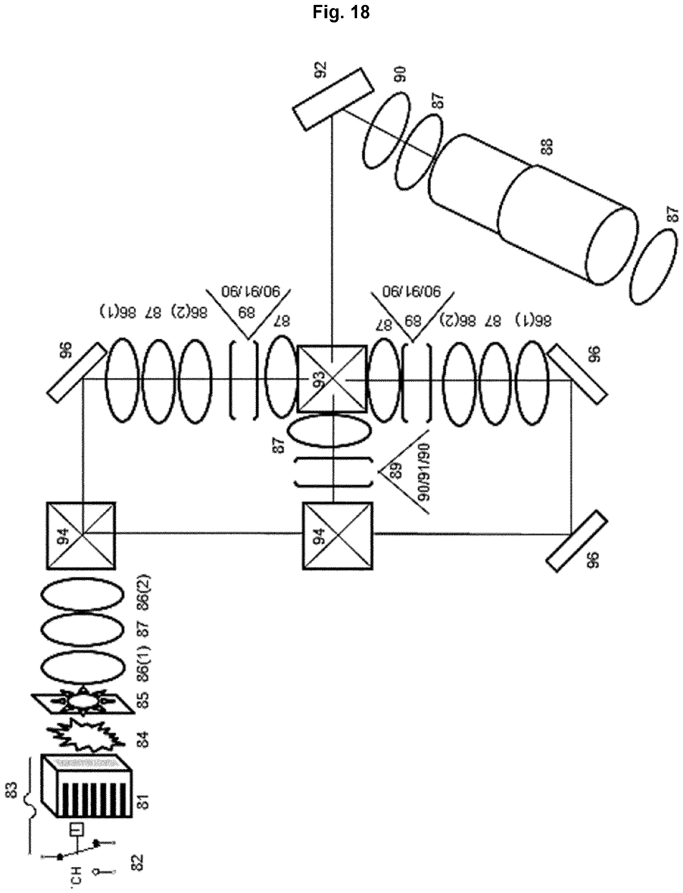

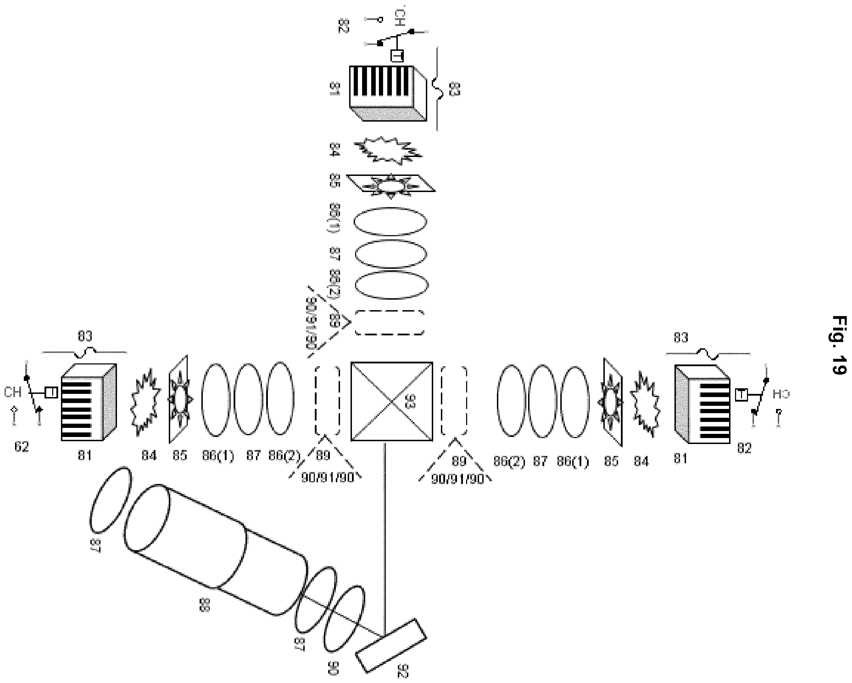

Die Figuren 11 bis 19 zeigen verschiedene Ausführungsbeispiele eines Erkennungsbereichskennzeichnungsgeräts als Spot-Light 80 des fokussierten Erkennungsbereichskennzeichnungsgeräts 8.

Die Figur 11 zeigt den einfachen Grundaufbau für ein einfarbiges
Erkennungsbereichskennzeichnungsgerät 8. Durch ein weisses oder bandbegrenztes Leuchtmittel 85 wird Licht erzeugt. Die entstehende Wärme wird durch ein optionales Wärmeleitmaterial 84 auf ein optionales Kühlungselement 81 beispielsweise einen Kühlkörper und/oder Ventilator und/oder einen Teil der Struktur abgeführt. Aus Sicherheitsgründen kann das Leuchtmittel 85 oder alternativ ein Teil in der Wärmeflusskette durch thermische Schutzelemente, wie beispielsweise einem Thermal-Switch 82 oder einer Temperatursicherung 83, abgesichert sein. Das Licht kann durch einen Filter 86, beispielsweise einen ein- oder mehrfachen Bandfilter, beispielsweise für infrarotes oder ultraviolettes Licht, optionale Linsen oder eine Linsengruppe 87 und ein optionales, verstellbares Fokussierungsrohr oder ein Objektiv 88 geführt und damit aufbereitet werden. Mit dem Erkennungsbereichskennzeichnungsgerät 8 können optional auch Bilder dargestellt werden, indem ein Farbfilter oder ein Lichtbild 89 mit einer Darstellungsinformation optional auf einem oder zwischen zwei Gläsern angebracht sind. Um mehrere Darstellungen zu ermöglichen, kann eine Darstellungswechselvorrichtung, Darstellungsaustauschvorrichtung oder Darstellungsrotationsvorrichtung vorgesehen werden.

Die Figur 12 zeigt den Grundaufbau für ein einfarbiges Erkennungsbereichskennzeichnungsgerät 8 mit einem Durchlassfilter. Figur 11 und Figur 12 unterscheiden sich dahingehend, dass statt dem Farbfilter oder Lichtbild 89 mindestens ein Ausrichtungsfilter 90, beispielsweise eine Fresnell-Linse und/oder ein elektronischer Durchlassfilter 91, beispielsweise ein LCD Chip, für die veränderbare Bilddarstellung verwendet werden. Mit dem Durchlassfilter kann das Licht auf jedem Pixel separat durchgelassen oder nicht durchgelassen werden und somit ein Bild dargestellt werden.

Die Figur 13 zeigt den Aufbau für ein mehrfarbiges Erkennungsbereichskennzeichnungsgerät 8 auf Basis eines einfachen Grundaufbaus oder eines Aufbaus mit Durchlassfilter. Eine Farbveränderung und/oder Bildveränderung kann durch ein rotierendes Farbrad oder Bildrad 95 mit Antrieb und Ansteuerung erzielt werden. Beim einfachen Grundaufbau variiert nur die Farbe für das gleiche Bild oder das Bild immer gleichzeitig mit der Farbe. Bei Verwendung eines Durchlassfilters können Bild und Farbe unabhängig voneinander auch schnell geändert werden und es können damit Bilder und/oder farbsequenzielle Filme dargestellt werden.

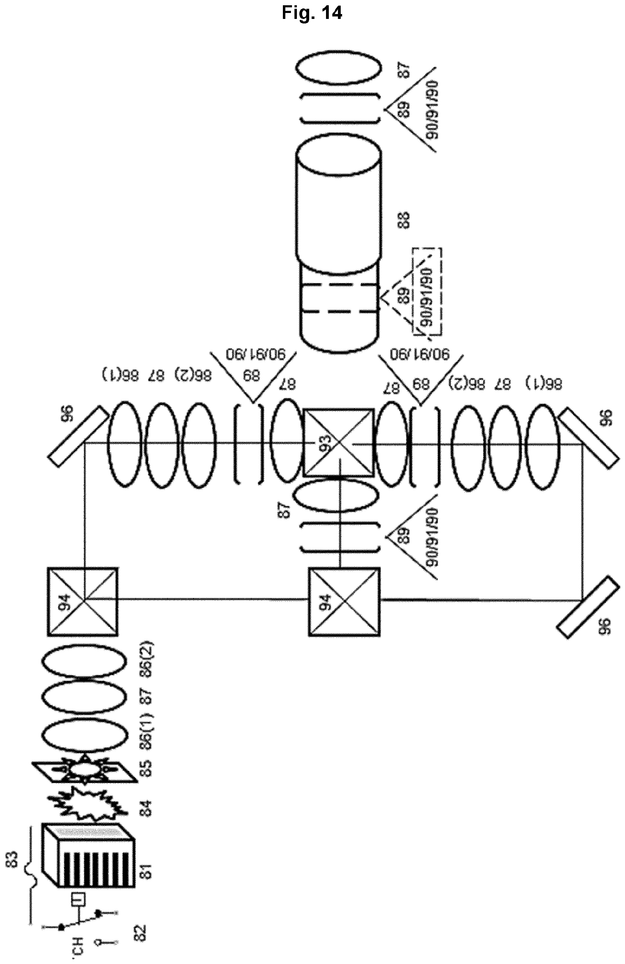

Die Figur 14 zeigt den Aufbau für ein mehrfarbiges Erkennungsbereichskennzeichnungsgerät 8 auf Basis eines einfachen Grundaufbaus oder eines Aufbaus mit Durchlassfilter. Bei diesem Aufbau wird das Licht mittels Aufsplittungsmodule 94 beispielsweise Dichroitische Prismen in die drei Grundfarben zerlegt und dann durch Farbfilter respektive Lichtbild 89 beim einfachen Grundaufbau respektive mittels mindestens einem Ausrichtungsfilter 90 und einem elektronischen Durchlassfilter 91 beim Aufbau mit Durchlassfilter bildmässig gestaltet. Das Licht der drei Grundfarben wird dann durch Umlenkspiegel 96 und Überlagerungsmodule 93 beispielsweise X-Prismen wieder zusammengefügt. Damit können Farben parallel und nicht nur sequenziell wie beim rotierenden Farbrad und/oder Bildrad 95 dargestellt werden.

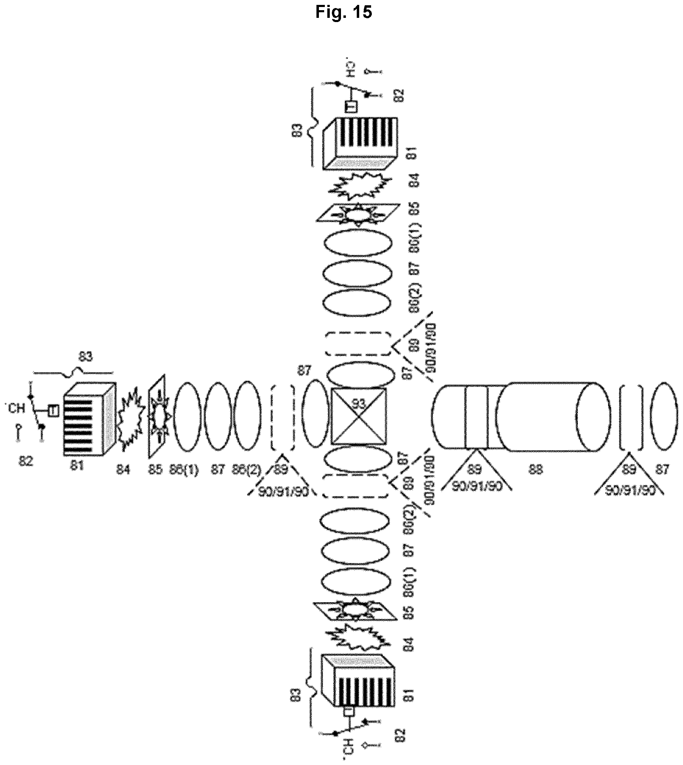

Die Figur 15 zeigt den Aufbau für ein mehrfarbiges Erkennungsbereichskennzeichnungsgeräts 8 auf Basis eines einfachen Grundaufbaus oder eines Aufbaus mit Durchlassfilter.
Figur 15 unterscheidet sich von Figur 14 dahingehend, dass die Grundfarben durch einzelne Leuchtmittel und nicht durch Aufsplittungsmodule 94 erzeugt werden.

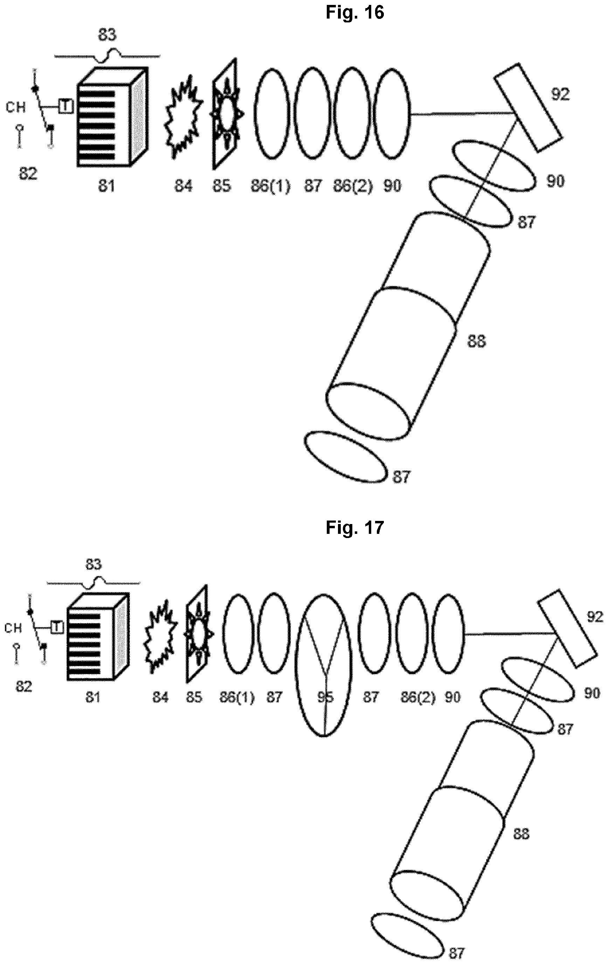

Die Figur 16 zeigt den Grundaufbau für ein einfarbiges Erkennungsbereichskennzeichnungsgeräts 8 mit einem Reflexionsfilter oder einem Spiegel. Der Unterschied zum Durchlassfilter in Figur 12 ist, dass beim Reflexionsfilter der Lichtstrahl nicht durchgelassen, sondern mittels eines elektronischen Reflexionsfilters 92 beispielsweise DLP oder LCoS Chip für jeden Pixel in die richtige Ausgangsrichtung oder eine andere Richtung weitergeleitet werden kann.

Die Figuren 17 bis 19 zeigen Ausführungsbeispiele eines Erkennungsbereichskennzeichnungsgeräts als mehrfarbiger Spot mit Reflexionsfilter, wobei die gleichen Erweiterungen wie beim Durchlassfilter gemäss Figuren 13 bis 15 bezogen auf den Reflexionsfilter verwendbar sind.

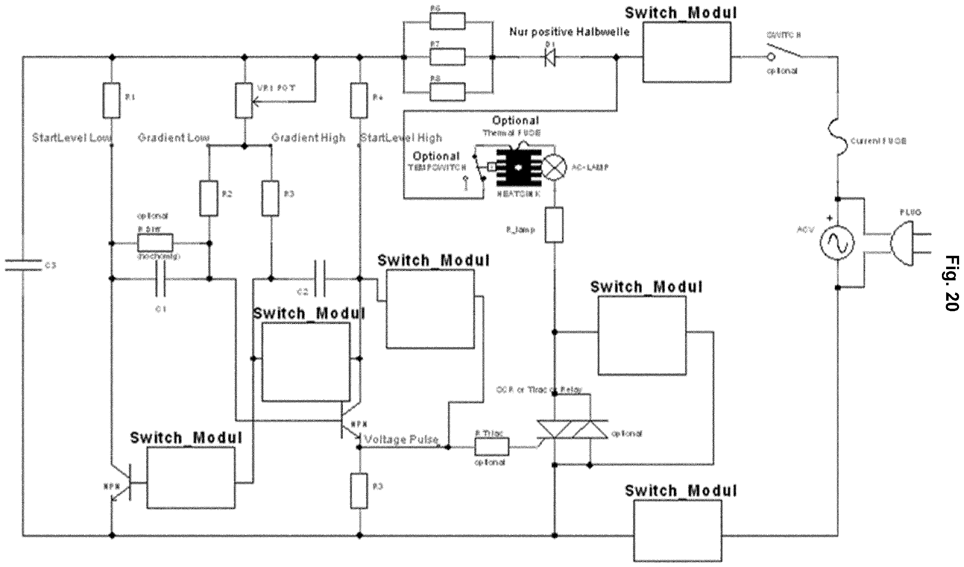

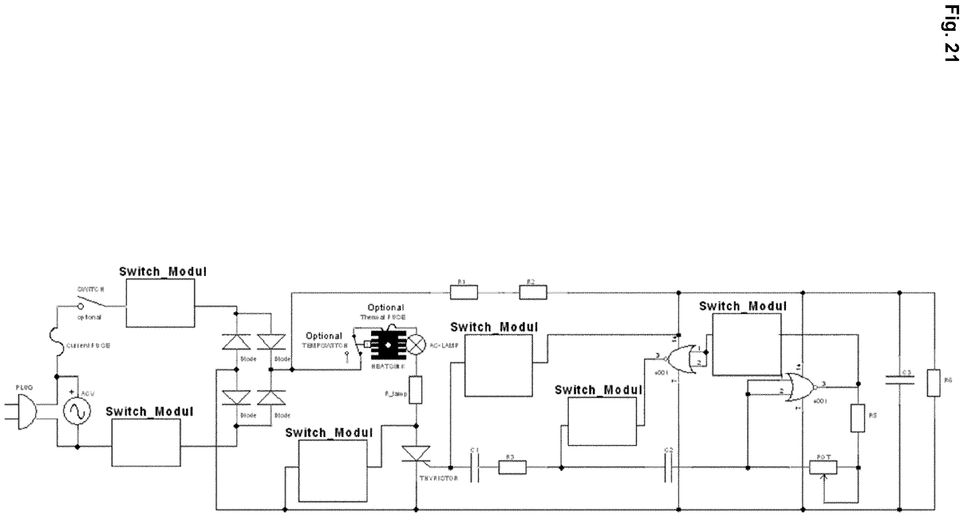

Die Figuren 20 und 21 zeigen Ausführungsbeispiele für einen einfachen Systemaufbau ohne Gleichspannungslogik. An den mit Switch-Modul gekennzeichneten Positionen können normale oder inverse, beliebige Schaltmodule, beispielsweise Relais, eingebaut werden, um beispielsweise mit der Erkennungsbereichskennzeichnung 7 bei einer ausreichenden Vorerkennung konstant zu leuchten und bei einer ausreichenden Erkennung und/oder Aktivierung und/oder Deaktivierung zu blinken.

Figur 22 zeigt ein Ausführungsbeispiel für einen umfassenden Aufbau mit Gleichspannungslogik für das berührungslose Bedienungselement 0. Das berührungslose Bedienungselement 0 umfasst die folgenden, teils optionalen Komponenten. Die Module und elektronischen Bauteilen können auf ein PCB 20 oder separat angebracht sein. Die Spannungsversorgung umfasst einen Versorgungsmodul 21, optional umfassend Steckern, AC-AC oder AC/DC oder DC/AC oder DC-DC Modulen, Stromsicherungen 22 und Schaltern 23. Mit einem Vorerkennung-Sensormodul 24, mindestens umfassend den berührungslosen Vorerkennungssensor 2, einem Erkennung-Sensormodul 25, mindestens umfassend den berührungslosen Erkennungssensor 4, und einem Steuerungslogikmodul 26 kann die Messung und Verarbeitung der Eingangssignale und die Bereitstellung der Aktuatoren- und Ausgangssignalen erfolgen. Zusätzlich umfasst das berührungslose Bedienungselement 0 Eingangsschaltmodule 27 und Ausgangsschaltmodule 28 mit Entkopplung von und zu anderen Systemen 39, beispielsweise Sensoren oder Funktionsobjekten 9 wie beispielsweise ein Türsystem. Diese Schaltmodule 27, 28 umfassen optional thermische Schutzelemente, wie beispielsweise einem Thermal-Switch 82 oder einer Temperatursicherung 83. Es kann eine separate visuelle Ausgabe vorhanden sein oder die Erkennungsbereichskennzeichnung 7 kann für die visuelle Ausgabe genutzt werden. Bei einem Erkennungsbereichskennzeichnungsgerät mit DC-Spannung 8a kann durch ein DC-Schaltmodul 30 geschaltet werden. Bei einem Erkennungsbereichskennzeichnungsgerät mit AC-Spannung 8b kann durch ein AC-Schaltmodul 29 geschaltet werden. In beiden Fällen wird Licht durch ein weisses oder bandbegrenztes Leuchtmittel 85 erzeugt. Die entstehende Wärme kann durch ein Wärmeleitmaterial 84 auf ein optionales Kühlungselement 81, beispielsweise einen Kühlkörper und/oder Ventilator und/oder einen Teil der Struktur abgeführt werden. Aus Sicherheitsgründen kann optional das Leuchtmittel 85, alternativ ein Teil in der Wärmeflusskette durch einen Thermal-Switch 82 oder eine Temperatursicherung 83 abgesichert sein. Weitere Details zu den verschiedenen Aufbaumöglichkeiten des Erkennungsbereichskennzeichnungsgeräts 8 werden in den Figuren 11 bis 19 beschrieben. Als Ausgaben sind eine separate visuelle Ausgabe oder die visuelle Ausgabe per Erkennungsbereichskennzeichnung 7 und/oder eine akustische Ausgabe 31, beispielsweise ein Sprach- oder Soundmodul mit Lautsprecher, und/oder eine haptische Ausgabe 32, beispielsweise ein Vibrationsmodul, vorgesehen. Alternativ kann ein Kommunikationsmodul 33 für eine optional drahtgebundene oder drahtlose, ein- oder ausgehende Kommunikation verwendet werden. Das Kommunikationsmodul 33 kann eine Kommunikationseinheit 110 enthalten, mit der eine Kommunikation von und zu einem Objektgerät 111, insbesondere zu einem Mobilfunkgerät, realisiert werden kann. Ein optionales I/O Modul 34 ist mindestens für die Eingangs- und Ausgangssignalbereit-stellung von Sensoren oder externer Kommunikation und Information oder Einstellungen und Konfiguration oder Default- und Testwerte von Ein- und/oder Ausgängen oder verschiedene Betriebs-, Kommunikations-, Ein- oder Ausgangsmodi vorgesehen. Das Ansteuerungsmodul 36 dient der Freischaltung von Funktionalitäten oder wird für Einstellungen oder Auswahlen genutzt. Optionale Zusatzsensoren 35 und vorhandenen Sensoren können Umgebungssensoren sein, die für die Kompensation, Fehlererkennung und Abschaltung bei Umgebungseinflüssen, beispielsweise Umgebungslicht oder Umgebungsgeräusche, oder als erweiterte Informationen zur Datenaufzeichnung dienen. Aktuelle und aufgezeichneten Daten können über die Logger-Anzeige 37 angezeigt, gespeichert, oder weiterkommuniziert werden. Alle Komponenten können fest oder optional über Stecker 38 verbunden sein, um eine bessere Austauchbarkeit bei allfälligen Reparaturen zu ermöglichen.

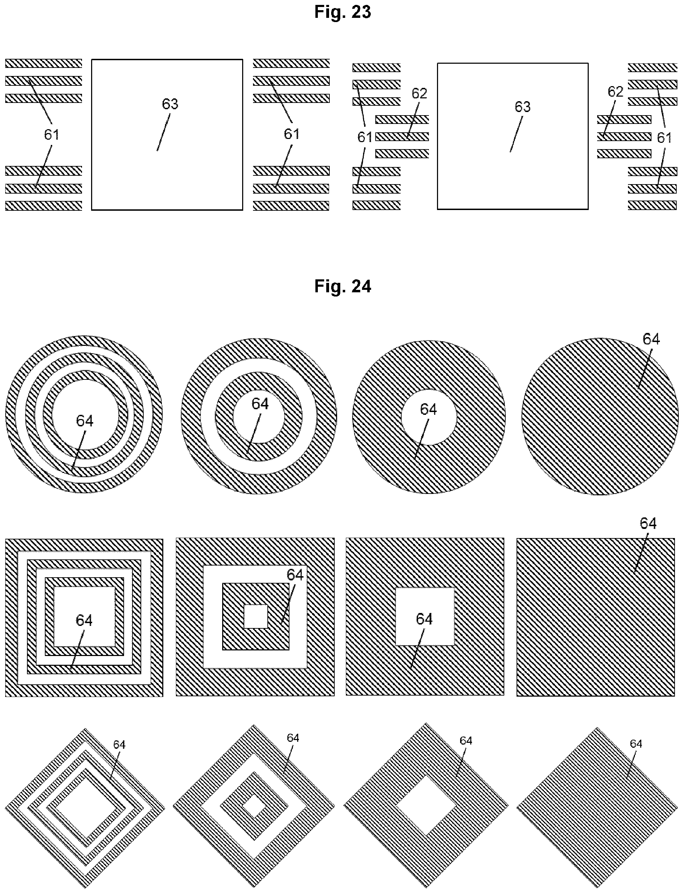

Die Figuren 23 und 24 zeigen eine feste Erkennungsbereichskennzeichnung 6 für Sehbehinderte, die ein erhobenes oder versenktes Profil hat.

Das optionale Sehbehindertenleitsystem 61 kann eine sehbehinderten Person entweder zum und/oder durch den Erkennungsbereich 3 und/oder dann weiter zum zugehörigen Funktionsobjekt 9 führen. Wenn eine sehbehinderte Person den Erkennungsbereich 3 erkennen soll, kann dieser durch feste Erkennungsbereichskennzeichnung für Sehbehinderte 64 gekennzeichnet sein. Ansonsten kann das Sehbehindertenleitsystem 61 ununterbrochen durch den Erkennungsbereich 3 führen und dann weiter zum zugehörigen Funktionsobjekt 9. Die Erkennungsbereichskennzeichnung für sehbehinderte Personen 64 kann zusätzlich erhaben oder vertieft sein, so dass sie mit einem Blindenstock ertastet werden kann und kann gleich oder unterschiedlich nach Funktionsobjekt und/oder abhängig von der benötigten Aktion sein.

Zusätzlich kann ein Sehbehindertenübergangsleitsystem 62 zwischen dem Sehbehindertenleitsystem 61 und der Erkennungsbereichskennzeichnung für sehbehinderte Personen 64 haben. Die Varianten des Sehbehindertenübergangsleitsystems 62 und der Erkennungsbereichskennzeichnung für sehbehinderte Personen 64 können beliebig kombiniert werden, was durch die Symbolplatzhalter 63 für Erkennungsbereichsmarkierungen für sehbehinderte Personen gezeigt wird.

Für den Fachmann ist offensichtlich, dass viele weitere Varianten zusätzlich zu den beschriebenen Ausführungsbeispielen möglich sind, ohne vom erfinderischen Konzept abzuweichen. Der Gegenstand der Erfindung wird somit durch die vorangehende Beschreibung nicht eingeschränkt und ist durch den Schutzbereich bestimmt, der durch die Ansprüche festgelegt ist. Für die Interpretation der Ansprüche oder der Beschreibung ist die breitest mögliche Lesart der Ansprüche massgeblich. Insbesondere sollen die Begriffe "enthalten" oder "beinhalten" derart interpretiert werden, dass sie sich auf Elemente, Komponenten oder Schritte in einer nicht-ausschliesslichen Bedeutung beziehen, wodurch angedeutet werden soll, dass die Elemente, Komponenten oder Schritte vorhanden sein können oder genutzt werden können, dass sie mit anderen Elementen, Komponenten oder Schritten kombiniert werden können, die nicht explizit erwähnt sind. Wenn die Ansprüche sich auf ein Element oder eine Komponente aus einer Gruppe beziehen, die aus A, B, C bis N Elementen oder Komponenten bestehen kann, soll diese Formulierung derart interpretiert werden, dass nur ein einziges Element dieser Gruppe erforderlich ist, und nicht eine Kombination von A und N, B und N oder irgendeiner anderen Kombination von zwei oder mehr Elementen oder Komponenten dieser Gruppe.

## Patentansprüche

1. System zur Bereichsüberwachung, umfassend ein berührungsloses Bedienungselement (0), umfassend mindestens einen berührungslosen Erkennungssensor (4) oder eine entsprechende Schnittstelle, wobei der berührungslose Erkennungssensor (4) oder die Schnittstelle zur Erkennung des Benutzungsobjekts (5) ausgebildet ist, wenn sich das Benutzungsobjekt (5) in einem Erkennungsbereich (3) befindet, der durch mindestens eine Erkennungsbereichskennzeichnung (6, 7) gekennzeichnet ist.

2. Das System nach Anspruch 1, wobei das berührungslose Bedienungselement (0) mindestens einen berührungslosen Vorerkennungssensor (2) oder eine entsprechende Schnittstelle umfasst, wobei der berührungslose Vorerkennungssensor (2) oder die Schnittstelle zur Erkennung des Benutzungsobjekts (5) ausgebildet ist, wenn sich das Benutzungsobjekt (5) in einem Vorerkennungsbereich (1) befindet, der grösser als der Erkennungsbereich (3) ist.

3. Das System nach einem der vorhergehenden Ansprüche, wobei der berührungslose Vorerkennungssensor (2) und/oder der berührungslose Erkennungssensor (4) und/oder die entsprechenden Schnittstellen mindestens je einen Sensor aus der Gruppe bestehend aus Bewegungssensoren, Näherungssensoren, Präsenzsensoren, Lichtschranken, Induktivsensoren, Induktionsschleifen, Ultraschall-, Kapazitivsensoren oder Drucksensoren, Lichtsensoren, Lichtschranken und Infrarotsensoren umfassen.

4. Das System nach einem der vorhergehenden Ansprüche, wobei die Erkennungsbereichskennzeichnung als eine feste Erkennungsbereichskennzeichnung (6) ausgebildet ist und/oder die Erkennungsbereichskennzeichnung (7) durch ein fokussiertes Erkennungsbereichskennzeichnungsgerät (8) dargestellt wird.

5. Das System nach Anspruch 4, wobei die Erkennungsbereichskennzeichnung (6 und/oder 7) eine Darstellung umfasst, die mindestens eine Darstellungsform und/oder Darstellungsinformation umfasst und über die Laufzeit gleichbleibend oder bei einer Erkennungsbereichskennzeichnung (7) durch ein Erkennungsbereichskennzeichnungsgerät (8) veränderlich ist.

6. Das System nach einem der vorhergehenden Ansprüche, wobei durch einen Zuordnungshinweis (120) in der Darstellung der Erkennungsbereichskennzeichnung (6, 7) und/oder durch mindestens eine Zuordnungskennzeichnung (121) das berührungslose Bedienungselement (0) dem zugehörigen Funktionsobjekt (9) und/oder deren Funktion und/oder deren Ablaufprozedur zuordenbar ist.

7. Das System nach einem der vorhergehenden Ansprüche, wobei das berührungslose Bedienungselement (0) mit mindestens einer Erkennungsbereichskennzeichnung (6, 7) für verschiedene Funktionsobjekte (9) und/oder verschiedene Funktionen und/oder verschiedene Ablaufprozeduren verwendbar ist, indem das berührungslose Bedienungselement (0) mehrere, unabhängige Erkennungen und/oder zeitlich wechselnde Erkennungen in der gleichen Erkennung umfasst.

8. Das System nach einem der vorhergehenden Ansprüche, wobei das berührungslose Bedienungselement (0) mindestens eine Eingabe und/oder Ausgabe mindestens aus der Gruppe bestehend aus einem Ausgangsschaltmodul (28) und/oder einem Kommunikationsmodul (33) und/oder einer visuellen und/oder akustischen (31) und/oder haptischen (32) und/oder kommunikationstechnischen (33) Eingabe und/oder Ausgabe und/oder einem Schaltmodul (29, 30) zur Veränderung der Erkennungsbereichskennzeichnung umfasst.

9. Das System nach einem der vorhergehenden Ansprüche, wobei das berührungslose Bedienungselement (0) mittels eines Schaltbefehlsmanagements und/oder eines Zustandsmanagements und/oder Zusatzinformationen den Schaltvorgang pro Funktionsobjekt (9) einzeln steuert und/oder optimiert.

10. Das System nach einem der vorhergehenden Ansprüche, wobei durch das berührungslose Bedienungselement (0), mittels des berührungslosen Erkennungssensors (4) und/oder des berührungslosen Vorerkennungssensors (2) und/oder der Schnittstellen und/oder mindestens eines Zusatzsensors (35), mindestens eine Zusatzinformation des Benutzungsobjekts (5) und/oder mindestens ein Umgebungseinfluss ermittelbar ist.

11. Das System nach einem der vorhergehenden Ansprüche, wobei das berührungslose Bedienungselement (0) mindestens einen Sensor aus der Gruppe bestehend aus einem Individualerkennungssensor und/oder einem Zugehörigkeitserkennungssensor und/oder einem Fortbewegungsunterstützungserkennungssensor umfasst.

12. Das System nach einem der vorhergehenden Ansprüche, wobei das berührungslose Bedienungselement (0) mindestens ein einzelnes und/oder mindestens teilweise kombiniertes Element aus der Gruppe bestehend aus einer Grundplatte (10), einer Struktur (11), einer Rohrstruktur für eine Fokussierung (16), einer Verkleidung (12), einem Kühlungs- und/oder Entlüftungssystem (13), einer Seriennummer, einem Barcode, einem QR-Code (14), einem Befestigungselement (15) umfasst.

13. Das System nach einem der vorhergehenden Ansprüche, wobei der berührungslose Erkennungssensor (4) und/oder der berührungslose Vorerkennungssensor (2) einen gerichteten Empfänger (45) und/oder einen gerichteten Sender (40) für eine fokussierte Transmissions- oder Reflexions- oder Benutzungsobjektabstrahlungsmessung umfasst.

14. Das System nach einem der Ansprüche 4 bis 13, wobei das fokussierte Erkennungsbereichskennzeichnungsgerät (8) ein Leuchtmittel (85) und/oder mindestens ein Element aus der Gruppe bestehend aus einem Kühlungselement (81), einem Wärmeleitmaterial (84), einem thermischen Schutzelement (82, 83), einem Filter (86), einer Linse und/oder Linsengruppe (87), einem Fokussierungsrohr oder Objektiv (88), einem Lichtbild (89), einem Ausrichtungsfilter (90), einem Überlagerungsmodul (93), einem Aufsplittungsmodul (94), einem Umlenkspiegel (96), einem elektronischen Durchlassfilter (91), einem Reflexionsfilter (92), einem rotierenden Farbrad und/oder Bildrad mit Antrieb und Ansteuerung (95) umfasst.

15. Das System nach einem der vorhergehenden Ansprüche, wobei das berührungslose Bedienungselement (0) mindestens durch eine Kommunikation und/oder ein Kommunikationsmodul (33) und/oder eine Kommunikationseinheit (110) und/oder ein Objektgerät (111) sein Verhalten anzeigen und/oder in seinem Verhalten beeinflusst und/oder ausgelöst wird.
